# EUROPÄISCHE PATENTSCHRIFT

(11) **EP 2 529 399 B1**
(45) Veröffentlichungstag und Bekanntmachung des Hinweises auf die Patenterteilung: **20.09.2017**
(21) Anmeldenummer: 11700426.7
(22) Anmeldetag: 17.01.2011
(51) Int. Cl.: H01L 25/075, H01L 33/50

(54) **BELEUCHTUNGSVORRICHTUNG**
ILLUMINATION DEVICE
DISPOSITIF D'ÉCLAIRAGE

(30) Priorität: 26.04.2010 DE 102010018260; 29.01.2010 DE 102010006135
(43) Veröffentlichungstag der Anmeldung: 05.12.2012
(73) Patentinhaber: OSRAM Opto Semiconductors GmbH, 93055 Regensburg (DE)
(72) Erfinder: SABATHIL, Matthias, 93059 Regensburg (DE); VON MALM, Norwin, 93152 Nittendorf - Thumhausen (DE); HOEPPEL, Lutz, 93087 Alteglofstein (DE); ILLEK, Stefan, 93093 Donaustauf (DE); BARCHMANN, Bernd, 93059 Regensburg (DE); RODE, Patrick, 93059 Regensburg (DE)
(74) Vertreter: Epping - Hermann - Fischer
(86) Internationale Anmeldenummer: PCT/EP2011/050541
(87) Internationale Veröffentlichungsnummer: WO 2011/092072

(56) Entgegenhaltungen:
- DE-A1-102007 043 401
- DE-A1-102008 005 935
- US-A- 5 469 020
- US-A1- 2005 212 406
- US-A1- 2005 265 029
- US-A1- 2008 123 355

## Beschreibung

Aus der Druckschrift US 7,217,956 B2 ist eine Beleuchtungsvorrichtung bekannt. In der Druckschrift US 2008/0123355 A1 ist eine Vorrichtung mit einem vorderseitigen Träger, einem rückseitigen Träger und einer Mehrzahl von lichtemittierenden Dioden beschrieben, bei der die lichtemittierenden Dioden zwischen den Trägern angeordnet und mittels der Träger elektrisch kontaktiert sind. In der Druckschrift US 2005/0265029 A1 ist eine Beleuchtungsanordnung angegeben, die lichtemittierende Dioden und eine Auskoppelschicht aufweist, wobei die Auskoppelschicht Lumineszenzkonversionsmaterial enthält.

Es ist eine Aufgabe der vorliegenden Offenbarung, eine Beleuchtungsvorrichtung anzugeben, die bei zufriedenstellend homogener Helligkeitsverteilung ohne aufwendige Maßnahmen zur Entwärmung auskommt.

Diese Aufgabe wird durch eine Beleuchtungsvorrichtung gemäß Patentanspruch 1 gelöst. Vorteilhafte Ausgestaltungen und Weiterbildungen der Beleuchtungsvorrichtung sind in den abhängigen Ansprüchen angegeben. Der Offenbarungsgehalt der Patentansprüche wird hiermit durch Rückbezug explizit in die Beschreibung mit aufgenommen.

Es wird eine Beleuchtungsvorrichtung angegeben. Beispielsweise handelt es sich bei der Beleuchtungsvorrichtung um eine Flächenlichtquelle. Die Beleuchtungsvorrichtung kann zur Allgemeinbeleuchtung ausgebildet sein. Alternativ kann sie beispielsweise eine - insbesondere rahmenlose - Hinterleuchtungsvorrichtung, zum Beispiel für ein LCD (Liquid Crystal Display, Flüssigkristallanzeigevorrichtung), darstellen.

Die Beleuchtungsvorrichtung weist eine Mehrzahl von Leuchtdiodenchips auf. Die Leuchtdiodenchips sind zur Emission von Licht, insbesondere von ultraviolettem, sichtbarem und/oder infrarotem Licht, und zur Emission von Verlustwärme ausgebildet. Dabei ist insbesondere lediglich die Emission des Lichts erwünscht. Im Betrieb der Beleuchtungsvorrichtung emittieren die Leuchtdiodenchips somit insbesondere Licht und geben Verlustwärme ab. Die Leuchtdiodenchips sind bei einer Ausgestaltung in einem Array, zum Beispiel an den Gitterpunkten eines gedachten hexagonalen, rechteckigen oder quadratischen Gitters angeordnet.

Die Leuchtdioden können alle Licht mit derselben dominanten Wellenlänge emittieren. Alternativ kann die Beleuchtungsvorrichtung mehrere Sorten von Leuchtdiodenchips mit voneinander verschiedenen dominanten Wellenlängen aufweisen, die insbesondere in regelmäßigen oder unregelmäßigen Mustern in dem Array angeordnet sind.

Die Leuchtdiodenchips weisen vorzugsweise eine anorganische Halbleiterschichtenfolge auf, die zur Lichterzeugung ausgebildet ist. Es ist auch denkbar, dass die Leuchtdiodenchips eine organische Schichtenfolge zur Strahlungserzeugung enthalten, so dass sie OLEDs darstellen. Alternativ zu Leuchtdiodenchips können grundsätzlich auch Laserdiodenchips verwendet sein.

Gemäß zumindest einem Aspekt weist die Beleuchtungsvorrichtung einen vorderseitigen Träger und einen rückseitigen Träger auf. Der rückseitige Träger ist in Draufsicht auf eine Vorderseite der Beleuchtungseinrichtung zumindest stellenweise von dem vorderseitigen Träger bedeckt. Bei einer Weiterbildung handelt es sich bei dem vorderseitigen Träger und/oder bei dem rückseitigen Träger jeweils um eine - insbesondere im Wesentlichen planparallele - Platte oder Folie, die beispielsweise mit Strukturierungen zur Beeinflussung der Lichtauskopplung und/oder elektrischen Anschlussschichten wie Leiterbahnen versehen sein kann. Der vorderseitige und der rückseitige Träger sind bei einer Weiterbildung biegsam ausgeführt. Insbesondere ist in diesem Fall die Beleuchtungsvorrichtung biegsam.

Die Leuchtdiodenchips sind zwischen dem rückseitigen Träger und dem vorderseitigen Träger angeordnet und von diesen insbesondere mechanisch arretiert. Auf diese Weise sind der vorderseitige Träger und vorzugsweise auch der rückseitige Träger insbesondere wärmeleitend an die Leuchtdiodenchips gekoppelt. Beispielsweise sind die Leuchtdiodenchips auf den rückseitigen Träger gelötet oder geklebt. Dabei sind die Leuchtdiodenchips vorzugsweise nicht in einzelnen Bauelement-Gehäusen eingebettet sondern als ungehäuste Chips an dem rückseitigen Träger montiert.

Mit dem vorderseitigen Träger kann beispielsweise eine reibungs-basierte Arretierung der Leuchtdiodenchips ausgebildet sein. Bei einer Ausgestaltung ist zwischen dem vorderseitigen Träger und dem rückseitigen Träger stellenweise ein Haftvermittlungsmaterial angeordnet, mittels welchem eine Zugspannung zwischen den Trägern erzielt ist. Das Haftvermittlungsmaterial enthält zum Beispiel einen Klebstoff, der dazu ausgebildet ist, beim Aushärten zu schrumpfen und so die Zugspannung hervorzurufen. Die Leuchtdiodenchips sind beispielsweise mittels der Zugspannung zwischen dem vorderseitigen und rückseitigen Träger eingespannt, so dass insbesondere der vorderseitige Träger an die Leuchtdiodenchips gepresst ist.

Vorzugsweise sind die Leuchtdiodenchips mittels des rückseitigen und/oder des vorderseitigen Trägers elektrisch kontaktiert. Beispielsweise sind sie auf eine elektrische Leiterbahn des rückseitigen Trägers gelötet oder - mittels eines elektrisch leitfähigen Klebers - geklebt.
Alternativ oder zusätzlich zur rückseitigen Kontaktierung mit einer Leiterbahn des rückseitigen Trägers können die Leuchtdiodenchips jeweils eine vorderseitige Kontaktschicht aufweisen, die mit einer elektrischen Anschlussschicht des vorderseitigen Trägers elektrisch leitend verbunden ist. Beispielsweise grenzen die vorderseitigen Kontaktschichten und die elektrische Anschlussschicht direkt aneinander an, insbesondere ohne eine dazwischen angeordnete Lot- oder Klebstoffschicht. Die vorderseitigen Kontaktschichten sind insbesondere lichtdurchlässig und vorzugsweise vollflächig auf die lichterzeugende Halbleiterschichtenfolge der jeweiligen Leuchtdiodenchips aufgebracht. Die elektrische Anschlussschicht ist vorzugsweise zumindest an den Stellen lichtdurchlässig, an denen sie mit den Leuchtdiodenchips überlappt. Die Kontaktschichten und/oder die lichtdurchlässigen Stellen der elektrischen Anschlussschicht des vorderseitigen Trägers weisen bei einer Ausgestaltung ein transparentes leitfähiges Oxid wie ITO (indium tin oxide, Indium-Zinn-Oxid) und/oder ZnO, insbesondere mit Al und/oder Ga dotiertes ZnO, auf.

Bei einer Weiterbildung weist der rückseitige Träger mindestens eine Leiterbahn auf, die zur vorderseitigen elektrischen Kontaktierung mindestens eines der Leuchtdiodenchips vorgesehen ist. Zudem ist bei dieser Weiterbildung mindestens ein elektrisches Brückenelement - zum Beispiel ein Metallblock oder ein Siliziumblock, der vorzugsweise so dotiert ist, dass er elektrisch leitfähig ist - zwischen dem vorderseitigen und dem rückseitigen Träger angeordnet. Das elektrische Brückenelement stellt einen elektrischen Kontakt zwischen der Leiterbahn des rückseitigen Trägers und der elektrischen Anschlussschicht des vorderseitigen Trägers her. Die Leuchtdiodenchips und das mindestens eine elektrische Brückenelement haben vorzugsweise etwa die gleiche Höhe. Auf diese Weise ist das Brückenelement in der gleichen Weise mit den Trägern arretierbar wie die Leuchtdiodenchips. Mittels solcher elektrischer Brückenelemente sind Serienschaltungen, Parallelschaltungen oder Kombinationen von Serien- und Parallelschaltungen der Leuchtdiodenchips besonders einfach realisierbar.

Gemäß zumindest einem Aspekt weist die Beleuchtungsvorrichtung eine Lichtauskoppelfläche auf. Die Lichtauskoppelfläche ist zur Auskopplung von Licht, das die Leuchtdiodenchips im Betrieb der Beleuchtungsvorrichtung erzeugen, aus der Beleuchtungsvorrichtung ausgebildet. Zweckmäßigerweise ist die Lichtauskoppelfläche von den Leuchtdiodenchips beleuchtet. Insbesondere überdeckt sie die Leuchtdiodenchips in Draufsicht auf die Vorderseite der Beleuchtungsvorrichtung.

Vorzugsweise weist der vorderseitige Träger die Lichtauskoppelfläche auf. Zweckmäßigerweise ist der vorderseitige Träger in diesem Fall zumindest stellenweise lichtdurchlässig, d.h. transluzent oder transparent. Der rückseitige Träger kann ebenfalls zumindest stellenweise lichtdurchlässig sein.

Gemäß zumindest einem Aspekt ist die Lichtauskoppelfläche zur Abgabe zumindest eines Teils der von den Leuchtdiodenchips erzeugten Verlustwärme an die Umgebung ausgebildet. Insbesondere ist die Lichtauskoppelfläche eine Außenfläche der Beleuchtungseinrichtung, vorzugsweise eine von den Leuchtdioden abgewandte Außenfläche des vorderseitigen Trägers. Die Lichtauskoppelfläche grenzt vorzugsweise an ein gasförmiges Medium, insbesondere an Luft, an.

Gemäß zumindest einem Aspekt ist jeder Leuchtdiodenchip im Betrieb der Beleuchtungsvorrichtung zur Ansteuerung mit einer elektrischen Nennleistung von 100 mW oder weniger vorgesehen. Die elektrische Nennleistung jedes Leuchtdiodenchips beträgt bei einer Ausgestaltung 5 mW oder mehr, vorzugsweise 20 mW oder mehr und insbesondere 40 mW oder mehr.

Vorzugsweise haben die Leuchtdiodenchips eine Lichtausbeute von 100 lm/W oder mehr. Leuchtdiodenchips mit solchen Lichtausbeuten sind dem Fachmann im Prinzip bekannt und werden daher an dieser Stelle nicht näher erläutert. Eine Obergrenze der Lichtausbeute ist physikalisch durch den maximal möglichen Wirkungsgrad begrenzt und beträgt zum Beispiel 350 lm/W.

Gemäß zumindest einem Aspekt haben die lateralen Abmessungen der Leuchtdiodenchips einen Wert von 300 µm oder weniger, vorzugsweise von 100 µm oder weniger. Beispielsweise handelt es sich um Leuchtdiodenchips, die in Draufsicht auf die Vorderseite eine rechteckige oder quadratische Kontur mit Kantenlängen von 300 µm oder weniger, vorzugsweise von 200 µm oder weniger, beispielsweise von 100 µm oder weniger haben. Bei einer Weiterbildung haben die lateralen Abmessungen einen Wert von 20 µm oder mehr, insbesondere von 50 µm oder mehr. Mit solchen lateralen Abmessungen sind Leuchtdiodenchips einer Leistung von 100 mW oder weniger besonders kostengünstig herstellbar.
Die lateralen Abmessungen der Leuchtdiodenchips sind dabei insbesondere die Kantenlängen der Leuchtdiodenchips. Enthalten die Leuchtdiodenchips beispielsweise eine lichterzeugende, epitaktische Halbleiterschichtenfolge auf einem Chipträgersubstrat, werden im vorliegenden Zusammenhang insbesondere die lateralen Abmessungen der lichterzeugenden, epitaktischen Halbleiterschichtenfolge als "laterale Abmessungen der Leuchtdiodenchips" angesehen. Die lateralen Abmessungen des Chipträgersubstrats können - beispielsweise zur Vereinfachung der Montage - merklich größer als die lateralen Abmessungen der lichterzeugenden, epitaktischen Halbleiterschichtenfolge sein.

Die Abstände zwischen einander benachbarten Leuchtdiodenchips sind gemäß zumindest einem Aspekt so groß gewählt, dass im Betrieb der Beleuchtungsvorrichtung bei Ansteuerung der Leuchtdiodenchips mit der elektrischen Nennleistung das von den Leuchtdiodenchips gebildete Array bezogen auf seine Grundfläche eine elektrische Leistungsaufnahme von kleiner oder gleich 450 W/m², bei einer Weiterbildung von kleiner oder gleich 300 W/m², hat.

Die Grundfläche des Arrays ist dabei insbesondere der Flächeninhalt eines vom Array - d.h. von den Leuchtdiodenchips des Arrays zusammen mit den Zwischenräumen zwischen den Leuchtdiodenchips - in Draufsicht auf die Lichtauskoppelfläche überdeckten Gebiets des rückseitigen Trägers. Der Flächeninhalt der Grundfläche des Arrays entspricht insbesondere dem Flächeninhalt der Lichtauskoppelfläche.

Vorzugsweise sind die Abstände zwischen einander benachbarten Leuchtdiodenchips so klein gewählt, dass im Betrieb der Beleuchtungsvorrichtung bei Ansteuerung der Leuchtdiodenchips mit der elektrischen Nennleistung das von den Leuchtdiodenchips gebildete Array in Draufsicht auf die Lichtauskoppelfläche Licht mit einer mittleren Leuchtdichte von größer oder gleich 2000 Cd/m², bei einer Weiterbildung von größer oder gleich 3000 Cd/m², emittiert.

Die mittlere Leuchtdichte ist insbesondere die über die Grundfläche des Arrays gemittelte Leuchtdichte des vom Leuchtdioden-Array in Draufsicht auf die Lichtauskoppelfläche - d.h. insbesondere in einen Raumwinkel von 2n - emittierten Lichts.

Insbesondere ergibt sich der Lichtstrom Φ aus dem Integral der Lichtstärke I über den Raumwinkel Ω. Daraus folgt bei beispielsweise bei isotroper Abstrahlung in einen Raumwinkel von Ω = 2n, dass die mittlere Leuchtdichte L bei einer Fläche A des Arrays einen Wert von L = I/A = Φ/(2π A) hat. Haben die Leuchtdiodenchips des Arrays beispielsweise eine lambert'sche Abstrahlcharakteristik hat die mittlere Leuchtdichte bei Abstrahlung in einen Raumwinkel von Ω = 2n wegen der cosförmigen Winkelabhängigkeit der Lichtstärke I einen Wert von L = Φ/(n A). Der Quotient aus Lichtstrom Φ und Fläche A ist dabei insbesondere gleich dem Produkt aus der Lichtausbeute der Leuchtdiodenchips und der auf die Fläche A bezogenen Leistungsaufnahme der Leuchtdiodenchips.

Alternativ oder zusätzlich sind gemäß zumindest einem Aspekt die Abstände zwischen einander benachbarten Leuchtdiodenchips so klein gewählt, dass im Betrieb der Beleuchtungsvorrichtung bei Ansteuerung der Leuchtdiodenchips mit der elektrischen Nennleistung das von den Leuchtdiodenchips gebildete Array bezogen auf seine Grundfläche eine elektrische Leistungsaufnahme von größer oder gleich 120 W/m², bei einer Weiterbildung von größer oder gleich 200 W/m², hat.

Die Abstände zwischen den Leuchtdiodenchips haben beispielsweise einen Wert von kleiner oder gleich 10 mm, insbesondere von kleiner oder gleich 5 mm, und/oder einen Wert von größer oder gleich 0,5 mm, insbesondere von größer oder gleich 1 mm. Bei einer Ausgestaltung haben sie einen Wert zwischen 0,5 mm und 5 mm, vorzugsweise zwischen 1 mm und 4 mm, wobei die Grenzen jeweils eingeschlossen sind.

Bei Verwendung von Leuchtdiodenchips mit derart geringen elektrischen Nennleistung in solchen lateralen Abständen kann vorteilhafterweise eine besonders gute Wärmespreizung mittels des rückseitigen Trägers und/oder des vorderseitigen Trägers erzielt werden. Auf diese Weise ist - anders als bei Verwendung von Leuchtdiodenchips mit höherer Leistung pro Leuchtdiodenchip in entsprechend größeren Abständen - die thermische Belastung in lateraler Richtung besonders gleichmäßig verteilt und die Gefahr einer übermäßigen Erwärmung der Leuchtdiodenchips ist besonders gering.

Insbesondere ist die Beleuchtungsvorrichtung auf diese Weise ohne zusätzlichen Kühlkörper mittels natürlicher Konvektion über die Lichtauskoppelfläche entwärmbar. Beispielsweise wird bei natürlicher Konvektion von der Lichtauskoppelfläche eine Wärmeleistung zwischen 5 W/(m²K) und 10 W/(m²K), zum Beispiel von etwa 7 W/(m²K), an die Luft abgegeben, an welche die Lichtauskoppelfläche angrenzt. Der Teilchentransport in der Luft erfolgt bei natürlicher Konvektion insbesondere aufgrund des Temperaturgradienten, der vom Unterschied zwischen der Temperatur der Lichtauskoppelfläche und der Temperatur der Umgebung hervorgerufen wird.

Insbesondere ist bei der mittels natürlicher Konvektion ohne zusätzlichen Kühlkörper entwärmten Beleuchtungsvorrichtung im Betrieb mit einer Flächenleistung von 450 W/m² oder weniger die Temperatur der Lichtauskoppelfläche um 65 K oder weniger, vorzugsweise um 60 K oder weniger, gegenüber der Umgebungstemperatur erhöht. Auf diese Weise kann eine Begrenzung der Temperaturerhöhung der Leuchtdiodenchips auf 70 K oder weniger und insbesondere auf höchstens 80 °C ohne zusätzlichen Kühlkörper erzielt werden. So ist vorteilhafterweise die Gefahr einer nicht zufriedenstellenden Effizienz der Leuchtdiodenchips aufgrund eines temperaturbedingten Effizienzrückgangs sowie einer temperaturbedingten Verkürzung der Lebensdauer der Leuchtdioden vergleichsweise gering.

Gemäß zumindest einem Aspekt sind die Abstände zwischen einander benachbarten Leuchtdiodenchips jeweils kleiner oder gleich dem 2,5-fachen, bevorzugt kleiner oder gleich dem 1,5-fachen, des Abstands zwischen der Lichtauskoppelfläche und den Leuchtdiodenchips. Auf diese Weise kann vorteilhafterweise eine besonders homogene Leuchtdichteverteilung der Lichtauskoppelfläche erzielt werden.

Der Abstand zwischen einander benachbarten Leuchtdiodenchips bzw. der Abstand zwischen den Leuchtdiodenchips und der Lichtauskoppelfläche ist - beispielsweise bei einer biegsamen oder gekrümmten Beleuchtungseinrichtung - insbesondere der jeweilige Abstand im gestreckten Zustand der Beleuchtungseinrichtung. Weist die Lichtauskoppelfläche eine Strukturierung auf, wird als Abstand zwischen den Leuchtdiodenchips und der Lichtauskoppelfläche insbesondere der über die Fläche jedes Leuchtdiodenchips und über alle Leuchtdiodenchips gemittelte Abstand zwischen den Leuchtdiodenchips und der Lichtauskoppelfläche angesehen.

Gemäß zumindest einem Aspekt sind die lateralen Abmessungen und/oder die elektrischen Nennleistungen der Leuchtdiodenchips, die Abstände zwischen einander benachbarten Leuchtdiodenchips und der Abstand zwischen den Leuchtdiodenchips und der Lichtauskoppelfläche derart aneinander angepasst, dass im Betrieb der Beleuchtungsvorrichtung die von den Leuchtdiodenchips erzeugte Verlustwärme die Temperatur der Lichtauskoppelfläche um 7 K oder mehr gegenüber der Umgebungstemperatur erhöht. Beispielsweise ist die Temperatur der Lichtauskoppelfläche zwischen 7 K und 65 K, insbesondere zwischen 7 K und 60 K, vorzugsweise zwischen 10 K und 50 K gegenüber der Umgebungstemperatur erhöht, wobei die Grenzen jeweils eingeschlossen sind. Bei einer Temperaturerhöhung der Lichtauskoppelfläche um 7 K oder mehr kann eine Entwärmung der Beleuchtungsvorrichtung über die Lichtauskoppelfläche mittels natürlicher Konvektion, insbesondere aufgrund der Größe des hervorgerufenen Temperaturgradienten, besonders effektiv erfolgen.

Gemäß zumindest einem Aspekt sind die lateralen Abmessungen und/oder die elektrischen Nennleistungen der Leuchtdiodenchips, die Abstände zwischen einander benachbarten Leuchtdiodenchips und der Abstand zwischen den Leuchtdiodenchips und der Lichtauskoppelfläche zusätzlich oder alternativ derart aneinander angepasst, dass im Betrieb der Beleuchtungsvorrichtung die von den Leuchtdiodenchips erzeugte Verlustwärme die Temperatur der Leuchtdiodenchips um 70 K oder weniger, vorzugsweise um 60 K oder weniger, gegenüber der Umgebungstemperatur erhöht. Insbesondere erfolgt die Anpassung dabei derart, dass die Verlustwärme die Temperatur der Leuchtdiodenchips bei einer Umgebungstemperatur von 25 °C oder weniger - beispielsweise bei einer Umgebungstemperatur zwischen 15 °C und 25 °C, wobei die Grenzen eingeschlossen sind - auf höchstens 80 °C, vorzugsweise auf höchstens 60 °C, erhöht.

Die Temperatur der Leuchtdiodenchips bzw. die Temperatur der Lichtauskoppelfläche bezeichnet insbesondere die Temperatur im Dauerbetrieb der Beleuchtungseinrichtung bei Ansteuerung der Leuchtdiodenchips mit deren elektrischer Nennleistung. Vorzugsweise wird die jeweilige Temperatur über die vorderseitige Oberfläche des jeweiligen Leuchtdiodenchips bzw. über die Lichtauskoppelfläche gemittelt. Als Umgebungstemperatur wird insbesondere die Temperatur des an die Lichtauskoppelfläche angrenzenden Mediums ohne die von den Leuchtdioden eingebrachte Verlustwärme, d.h. im ausgeschalteten Zustand der Beleuchtungsvorrichtung bzw. in großem Abstand von der Beleuchtungsvorrichtung, verstanden. Beispielsweise handelt es sich bei der Umgebungstemperatur um die Raumtemperatur.

Gemäß zumindest einem Aspekt ist die Beleuchtungsvorrichtung zusätzlich zur Entwärmung mittels Wärmeabgabe an einer rückseitigen, d.h. von den Leuchtdiodenchips abgewandten, Außenfläche des rückseitigen Trägers ausgebildet. Die rückseitige Außenfläche des rückseitigen Trägers stellt insbesondere analog zur Lichtauskoppelfläche des vorderseitigen Trägers eine Außenfläche der Beleuchtungsvorrichtung dar, die beispielsweise an ein gasförmiges Medium wie Luft angrenzt.

Der Abstand zwischen der Lichtauskoppelfläche und den Leuchtdiodenchips ist bei einer Ausgestaltung kleiner oder gleich 5 mm, vorzugsweise kleiner oder gleich 4 mm. Auf diese Weise kann eine besonders geringe Bauhöhe der Beleuchtungseinrichtung erzielt werden, wobei aufgrund der geringen Abmessungen und Abstände der Leuchtdiodenchips zugleich eine zufriedenstellend homogene Leuchtdichteverteilung des von der Beleuchtungseinrichtung abgestrahlten Lichts über die Lichtauskoppelfläche erzielbar ist.

Bevorzugt ist die Beleuchtungsvorrichtung frei von einem metallischen Kühlkörper, insbesondere von einem metallischen Kühlkörper, der Kühlrippen aufweist. Beispielsweise sind die Bereiche des vorderseitigen bzw. rückseitigen Trägers, welche die zur Wärmeabgabe vorgesehene rückseitige Außenfläche bzw. die Lichtauskoppelfläche enthalten, aus einem Glasmaterial und/oder einem Kunststoffmaterial gebildet. Auf diese Weise sind mit Vorteil Beleuchtungsvorrichtungen erzielbar, die eine besonders geringe Bauhöhe aufweisen. Beispielsweise hat die Beleuchtungsvorrichtung bei einer Ausgestaltung eine Bauhöhe von kleiner oder gleich 10 mm, insbesondere von kleiner oder gleich 5 mm. Zudem ist die Beleuchtungsvorrichtung besonders kostengünstig herstellbar und kann biegsam ausgeführt sein.

Gemäß zumindest einem Aspekt haben die Leuchtdiodenchips eine Höhe, d.h. eine Ausdehnung in Richtung von der Vorderseite zur Rückseite hin, von 15 µm oder weniger, vorzugsweise von 10 µm oder weniger, beispielsweise von 5 µm oder weniger. Die Höhe ist insbesondere 2 µm oder größer, beispielsweise 3 µm oder größer.

Bei einer Weiterbildung sind die Leuchtdiodenchips substratlose Leuchtdiodenchips. "Substratlose Leuchtdiodenchips" sind insbesondere Leuchtdiodenchips, die eine lichtemittierende, epitaktische Halbleiterschichtenfolge aufweisen, die von ihrem Aufwachssubstrat abgelöst ist. Vorzugsweise ist die epitaktische Halbleiterschichtenfolge eines substratlosen Leuchtdiodenchips auch nicht an einem vom Aufwachssubstrat - sowie vom vorderseitigen und rückseitigen Träger der Beleuchtungsvorrichtung - verschiedenen Chipträgersubstrat befestigt. Beispielsweise besteht ein substratloser Leuchtdiodenchip aus der epitaktischen Halbleiterschichtenfolge, die mit einer Kontaktschicht zur n-seitigen Kontaktierung und/oder Kontaktschicht zur p-seitigen Kontaktierung vorderseitig und/oder rückseitig versehen ist. Die Kontaktschichten enthalten beispielsweise ein Metall, etwa Ag und/oder Au, und/oder ein transparentes leitfähiges Oxid (TCO, transparent conductive oxide) wie ITO und/oder ZnO.

Die Abführung der Verlustwärme, insbesondere zum rückseitigen Träger, ist bei Leuchtdiodenchips mit derart geringen Höhen wie etwa substratlosen Leuchtdiodenchips besonders effizient, so dass die von den Leuchtdiodenchips im Betrieb erzeugte Verlustwärme deren Temperatur mit Vorteil besonders wenig erhöht.

Gemäß zumindest einem Aspekt ist zwischen den Leuchtdiodenchips und dem vorderseitigen Träger ein Brechungsindex-Anpassungsmaterial, etwa ein Silikon-basiertes Fluid angeordnet. Beispielsweise weicht der Brechungsindex des Brechungsindex-Anpassungsmaterials um 1 oder weniger von dem Brechungsindex des Materials des jeweiligen Leuchtdiodenchips ab, das an das Brechungsindex-Anpassungsmaterial angrenzt und der Brechungsindex des Brechungsindex-Anpassungsmaterials weicht um 1 oder weniger von dem Brechungsindex des Materials des vorderseitigen Trägers ab, das an das Brechungsindex-Anpassungsmaterial angrenzt. Vorzugsweise liegt der Brechungsindex des Brechungsindex-Anpassungsmaterials zwischen dem Brechungsindex des Materials, an das es vorderseitig angrenzt und dem Brechungsindex des Materials, an das es rückseitig angrenzt.

Bei einer Weiterbildung weist eine dem vorderseitigen Träger zugewandte Hauptfläche jedes Leuchtdiodenchips eine wannenförmige Vertiefung auf, welche mit dem Brechungsindex-Anpassungsmaterial gefüllt ist. Beispielsweise ist die vorderseitige Kontaktschicht des Leuchtdiodenchips zur Bildung der wannenförmigen Vertiefung als Rahmen ausgebildet. Die Kontaktschicht überdeckt in diesem Fall in Draufsicht auf die Vorderseite insbesondere einen umlaufenden Randbereich der Halbleiterschichtenfolge des Leuchtdiodenchips und lässt einen vom Randbereich umschlossenen Mittelbereich der Halbleiterschichtenfolge frei. Das Brechungsindex-Anpassungsmaterial ist insbesondere in dem Mittelbereich angeordnet. Eine solche Ausgestaltung kann beispielsweise vorteilhaft sein, wenn die Halbleiterschichtenfolge des Leuchtdiodenchips vorderseitig zur Verbesserung der Lichtauskopplung aufgeraut ist.

Gemäß zumindest einem Aspekt umschließt der vorderseitige Träger eine Mehrzahl voneinander getrennter Kavitäten, wobei jede Kavität mit einem der Leuchtdiodenchips überlappt. Insbesondere ist jede Kavität mit einem Lumineszenzkonversionselement, das einen Leuchtstoff enthält, teilweise oder vollständig gefüllt. Die Kavitäten sind von einem - insbesondere lichtdurchlässigen - Grundkörper des vorderseitigen Trägers vorzugsweise vollständig umschlossen. Der Grundkörper kann dabei mehrteilig aufgebaut sein. Beispielsweise weist er ein erstes Teilstück mit Vertiefungen auf, welche von einem zweiten Teilstück zur Bildung der Kavitäten überdeckt werden.

Bei einer bevorzugten Ausgestaltung überdeckt jede Kavität in Draufsicht auf die Vorderseite der Beleuchtungsvorrichtung genau einen Leuchtdiodenchip vollständig und ist von den übrigen Leuchtdiodenchips lateral beabstandet. Die lateralen Abmessungen der Kavitäten sind vorzugsweise kleiner oder gleich dem 3-fachen, insbesondere kleiner oder gleich dem doppelten, der entsprechenden lateralen Abmessung des Leuchtdiodenchips, mit dem die jeweilige Kavität überlappt. Auf diese Weise kann eine Beleuchtungsvorrichtung erzielt werden, die im ausgeschalteten Zustand nicht in der Farbe des Leuchtstoffs erscheint, was vom Betrachter als störend empfunden werden kann.

Bei einer Weiterbildung enthält ein erster, dem jeweiligen Leuchtdiodenchip zugewandter Teilbereich jeder Kavität das Lumineszenzkonversionselement und ein zweiter, von dem jeweiligen Leuchtdiodenchip abgewandter Teilbereich der Kavität ist mit einem Material, insbesondere einem Gas wie Luft, gefüllt, das einen niedrigeren Brechungsindex hat, als das Material des vorderseitigen Trägers, welches die Kavität in Richtung zur Lichtauskoppelfläche hin begrenzt. Der zweite Teilbereich weist bei einer Ausgestaltung eine gekrümmte Oberfläche auf. Mittels des zweiten Teilbereichs kann eine besonders gute Lichtmischung im vorderseitigen Träger erzielt werden, so dass - insbesondere bei einer geringen Bauhöhe der Beleuchtungsvorrichtung - eine besonders gute Homogenität der Leuchtdichteverteilung der Lichtauskoppelfläche erzielt werden kann.

Gemäß zumindest einem Aspekt enthält der vorderseitige Träger eine Licht streuende und/oder diffus reflektierende Schicht. Zur Lichtstreuung und/oder zur diffusen Reflexion enthält die Licht streuende und/oder diffus reflektierende Schicht insbesondere Streupartikel, die vorzugsweise in einem Matrixmaterial, etwa einem Silikon-basierten Matrixmaterial eingebettet sind. Bei einer Ausgestaltung umschließt die Licht streuende und/oder diffus reflektierende Schicht die Lumineszenzkonversionselemente seitlich. Insbesondere sind die Seitenwände der Kavitäten des vorderseitigen Trägers von der Licht streuenden und/oder diffus reflektierenden Schicht gebildet.

Gemäß zumindest einem Aspekt wird eine Beleuchtungsvorrichtung mit einem vorderseitigen Träger, einem rückseitigen Träger und einer Mehrzahl von Leuchtdiodenchips, die im Betrieb der Beleuchtungseinrichtung Licht emittieren und Verlustwärme abgeben, angegeben, wobei der rückseitige Träger zumindest stellenweise von dem vorderseitigen Träger bedeckt ist und die Leuchtdiodenchips so zwischen dem rückseitigen Träger und dem vorderseitigen Träger angeordnet sind, dass sie ein Array bilden. Die Leuchtdioden sind mittels des rückseitigen und/oder des vorderseitigen Trägers elektrisch kontaktiert und von dem rückseitigen Träger und dem vorderseitigen Träger mechanisch arretiert. Der vorderseitige Träger ist wärmeleitend an die Leuchtdiodenchips gekoppelt und weist eine von den Leuchtdiodenchips abgewandte Lichtauskoppelfläche auf, die zur Abgabe eines Teils der von den Leuchtdiodenchips abgegebenen Verlustwärme an die Umgebung ausgebildet ist. Jeder Leuchtdiodenchip ist zur Ansteuerung mit einer elektrischen Nennleistung von 100 mW oder weniger im Betrieb der Beleuchtungsrichtung vorgesehen und hat eine Lichtausbeute von 100 lm/W oder mehr. Die Abstände zwischen einander benachbarten Leuchtdiodenchips sind so groß gewählt sind, dass im Betrieb der Beleuchtungsvorrichtung bei Ansteuerung der Leuchtdiodenchips mit der elektrischen Nennleistung das von den Leuchtdiodenchips gebildete Array bezogen auf seine Grundfläche eine elektrische Leistungsaufnahme von kleiner oder gleich 450 W/m² hat. Die Abstände zwischen einander benachbarten Leuchtdiodenchips sind so klein gewählt, dass im Betrieb der Beleuchtungsvorrichtung bei Ansteuerung der Leuchtdiodenchips mit der elektrischen Nennleistung das von den Leuchtdiodenchips gebildete Array in Draufsicht auf die Lichtauskoppelfläche Licht mit einer mittleren Leuchtdichte von größer oder gleich 2000 Cd/m² emittiert. Zudem sind die Abstände kleiner oder gleich dem 2,5-fachen des Abstands zwischen der Lichtauskoppelfläche und den Leuchtdiodenchips.

Die Abstände zwischen den Leuchtdiodenchips haben bei einer Ausgestaltung einen Wert von kleiner oder gleich 10 mm, beispielsweise kleiner oder gleich 5 mm, zum Beispiel haben sie einen Wert zwischen 0,5 mm und 5 mm, vorzugsweise zwischen 1 mm und 4 mm, wobei die Grenzen jeweils eingeschlossen sind. Der Abstand zwischen den Leuchtdiodenchips und der Lichtauskoppelfläche hat beispielsweise einen Wert zwischen 3 mm und 5 mm, wobei die Grenzen eingeschlossen sind, zum Beispiel hat er einen Wert von 4 mm. Bei einer Weiterbildung hat die elektrische Nennleistung jedes Leuchtdiodenchips einen Wert von größer oder gleich 2 mW, insbesondere einen Wert zwischen 20 mW und 60 mW, wobei die Grenzen eingeschlossen sind.

Mit Vorteil kann auf diese Weise eine Beleuchtungsvorrichtung mit geringer Bauhöhe erzielt werden, die ohne metallischen Kühlkörper mittels natürlicher Konvektion entwärmbar ist. Gemäß zumindest einem Aspekt wird eine Beleuchtungsvorrichtung mit einem vorderseitigen Träger, einem rückseitigen Träger und einer Mehrzahl von zur Emission von Licht und Verlustwärme ausgebildeten Leuchtdiodenchips angegeben, wobei der rückseitige Träger zumindest stellenweise von dem vorderseitigen Träger bedeckt ist, die Leuchtdiodenchips zwischen dem rückseitigen Träger und dem vorderseitigen Träger angeordnet und von diesen mechanisch arretiert und mittels des rückseitigen und/oder des vorderseitigen Trägers elektrisch kontaktiert sind, der vorderseitige Träger eine von den Leuchtdiodenchips abgewandte Lichtauskoppelfläche aufweist, die zur Abgabe eines Teils der von den Leuchtdiodenchips erzeugten Verlustwärme an die Umgebung ausgebildet ist, und die lateralen Abmessungen der Leuchtdiodenchips, die Abstände zwischen einander benachbarten Leuchtdiodenchips und der Abstand zwischen den Leuchtdiodenchips und der Lichtauskoppelfläche derart aneinander angepasst sind, dass im Betrieb der Beleuchtungsvorrichtung die von den Leuchtdiodenchips erzeugte Verlustwärme die Temperatur der Leuchtdiodenchips um 70 K oder weniger gegenüber der Umgebungstemperatur erhöht und die Temperatur der Lichtauskoppelfläche um 7 K oder mehr gegenüber der Umgebungstemperatur erhöht.

Mit Vorteil kann auf diese Weise ebenfalls eine Beleuchtungsvorrichtung mit geringer Bauhöhe erzielt werden, die ohne metallischen Kühlkörper mittels natürlicher Konvektion entwärmbar ist.

Gemäß zumindest einem Aspekt sind die lateralen Abmessungen der Leuchtdiodenchips, die Abstände zwischen einander benachbarten Leuchtdiodenchips und der Abstand zwischen den Leuchtdiodenchips und der Lichtauskoppelfläche derart aneinander angepasst, dass im Betrieb der Beleuchtungsvorrichtung die von den Leuchtdiodenchips erzeugte Verlustwärme die Temperatur der Leuchtdiodenchips um 70 K oder weniger gegenüber der Umgebungstemperatur erhöht und die Temperatur der Lichtauskoppelfläche um 7 K oder mehr gegenüber der Umgebungstemperatur erhöht, indem die lateralen Abmessungen der Leuchtdiodenchips kleiner oder gleich 300 µm, insbesondere kleiner oder gleich 100 µm gewählt werden, die Abstände zwischen den Leuchtdiodenchips kleiner oder gleich 10 mm, insbesondere kleiner oder gleich 5 mm, beispielsweise zwischen 0,5 mm und 5 mm, vorzugsweise zwischen 1 mm und 4 mm gewählt werden und der Abstand zwischen den Leuchtdiodenchips und der Lichtauskoppelfläche zwischen 3 mm und 5 mm, zum Beispiel gleich 4 mm, gewählt wird. Bei einer Weiterbildung hat die elektrische Nennleistung jedes Leuchtdiodenchips einen Wert zwischen 2 mW und 100 mW, insbesondere zwischen 20 mW und 60 mW, wobei die Grenzen jeweils eingeschlossen sind.

Weitere Vorteile und vorteilhafte Ausgestaltungen und Weiterbildungen der Beleuchtungsvorrichtung ergeben sich aus den folgenden, in Zusammenhang mit den Figuren beschriebenen, exemplarischen Ausführungsbeispielen.

Es zeigen:
- Figur 1,: einen schematischen Querschnitt durch einen Ausschnitt einer Beleuchtungsvorrichtung gemäß einem ersten exemplarischen Ausführungsbeispiel,
- Figur 2,: einen schematischen Querschnitt durch einen Leuchtdiodenchip der Beleuchtungsvorrichtung des Ausführungsbeispiels der Figur 1,
- Figur 3,: einen schematischen Querschnitt durch einen Ausschnitt einer Beleuchtungsvorrichtung gemäß einem zweiten exemplarischen Ausführungsbeispiel,
- Figur 4,: einen schematischen Querschnitt durch einen Ausschnitt einer Beleuchtungsvorrichtung gemäß einem dritten exemplarischen Ausführungsbeispiel,
- Figur 5,: einen schematischen Querschnitt durch einen Ausschnitt einer Beleuchtungsvorrichtung gemäß einem vierten exemplarischen Ausführungsbeispiel,
- Figur 6,: einen schematischen Querschnitt durch einen Ausschnitt einer Beleuchtungsvorrichtung gemäß einem fünften exemplarischen Ausführungsbeispiel,
- Figur 7,: einen schematischen Querschnitt durch einen Ausschnitt einer Beleuchtungsvorrichtung gemäß einem sechsten exemplarischen Ausführungsbeispiel,
- Figur 8,: einen schematischen Querschnitt durch einen Ausschnitt einer Beleuchtungsvorrichtung gemäß einem siebten exemplarischen Ausführungsbeispiel,
- Figur 9,: ein Diagramm der Temperaturerhöhung der Lichtauskoppelfläche in Abhängigkeit von der Kantenlänge der Beleuchtungsvorrichtung bei dem zweiten Ausführungsbeispiel.

In den Ausführungsbeispielen und Figuren sind gleiche oder gleich wirkende Bestandteile mit denselben Bezugszeichen versehen. Die Größenverhältnisse der Figuren und der in den Figuren dargestellten Elemente untereinander sind nicht als maßstabsgetreu zu betrachten, es sei denn, Einheiten sind explizit angegeben. Vielmehr können einzelne Elemente zur Verbesserung der Darstellbarkeit und/oder Verständlichkeit übertrieben groß und/oder dick dargestellt sein.

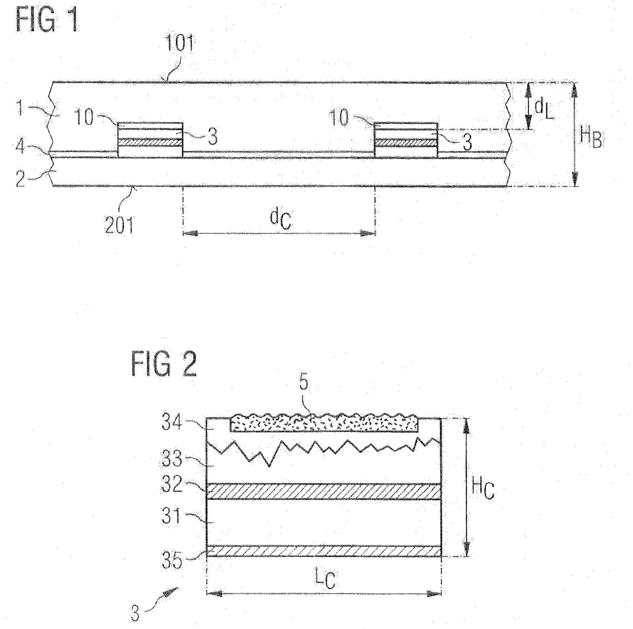

Figur 1 zeigt einen schematischen Querschnitt durch einen Ausschnitt einer Beleuchtungsvorrichtung gemäß einem ersten exemplarischen Ausführungsbeispiel.
Die Beleuchtungsvorrichtung gemäß dem ersten Ausführungsbeispiel weist einen vorderseitigen Träger 1 und einen rückseitigen Träger 2 auf. Der rückseitige Träger 2 ist vorliegend in Draufsicht auf eine Vorderseite der Beleuchtungsvorrichtung vollständig vom vorderseitigen Träger 1 überdeckt. Insbesondere sind die beiden Träger 1, 2 lateral bündig zueinander und haben beispielsweise eine quadratische Grundfläche mit einer Kantenlänge von 30 cm.

In Vertiefungen des vorderseitigen Trägers 1 sind Leuchtdiodenchips 3 aufgenommen, die zur Emission von Licht vorgesehen sind und im Betrieb zusätzlich zum Licht Verlustwärme abgeben. Die Leuchtdiodenchips 3 sind zwischen dem vorderseitigen Träger 1 und dem rückseitigen Träger 2 so angeordnet, dass sie ein Array bilden. Beispielsweise sind sie an den Gitterpunkten eines gedachten regelmäßigen und insbesondere rechteckigen oder quadratischen Gitters angeordnet.

Figur 2 zeigt einen schematischen Querschnitt durch einen Leuchtdiodenchip der Beleuchtungsvorrichtung des Ausführungsbeispiels der Figur 1.

Die Leuchtdiodenchips 3 sind vorliegend substratlose Leuchtdiodenchips, die jeweils aus einer epitaktischen Halbleiterschichtenfolge 31, 32, 33 und zwei Kontaktschichten 34, 35 bestehen. Die Höhe H_{C} der Leuchtdiodenchips hat insbesondere einen Wert zwischen 3 µm und 15 µm, vorzugsweise zwischen 3 µm und 10 µm, zum Beispiel zwischen 5 µm und 10 µm, wobei die Grenzen jeweils eingeschlossen sind. Beispielsweise sind die Leuchtdiodenchips 3 im Betrieb der Beleuchtungsvorrichtung zur Ansteuerung mit einer Nennleistung vorgesehen, die einen Wert zwischen 0,5 mW und 10 mW hat, wobei die Grenzen eingeschlossen sind, zum Beispiel zur Ansteuerung mit einer Nennleistung von etwa 2 mW. Die Lichtausbeute der Leuchtdiodenchips 3 beträgt vorliegend 115 lm/W. Die lateralen Abmessungen L_{C} der - vorliegend in Draufsicht quadratischen - Leuchtdiodenchips 3 betragen vorliegend etwa 200 µm.

Die epitaktische Halbleiterschichtenfolge weist eine Schicht eines ersten Leitfähigkeitstyps und eine Schicht eines zweiten Leitfähigkeitstyps - zum Beispiel eine p-leitende Schicht 31 und eine n-leitende Schicht 33 - auf, zwischen denen eine aktive, zur Lichterzeugung ausgebildete aktive Schicht 32 angeordnet ist. Es ist auch denkbar, dass die n-Seite und die p-Seite des Leuchtdiodenchips 3 in umgekehrter Reihenfolge angeordnet sind. Die aktive Schicht enthält insbesondere einen pn-Übergang, eine Doppelheterostruktur, eine Einfachquantentopfstruktur oder eine Mehrfachquantentopfstruktur zur Lichterzeugung. Die Halbleiterschichtenfolge 31, 32, 33 basiert beispielsweise auf einem III/V-Verbindungshalbleitermaterial wie AlInGaN oder InGaAlP.

Auf die vorderseitige, von der aktiven Schicht 32 abgewandte Oberfläche der n-leitenden Schicht 33, die vorliegend zur Verbesserung der Lichtauskopplung aufgeraut ist, ist eine erste Kontaktschicht 34 aufgebracht. Die erste Kontaktschicht 34 besteht vorliegend aus ITO und/oder ZnO, insbesondere mit Al und/oder Ga dotiertem ZnO, d.h. ZnO:(Al,Ga). Die vorderseitige Oberfläche des Leuchtdiodenchips 3 ist vorzugsweise frei von einer Metallschicht wie einem Bondpad. Auf diese Weise kann ein besonders großer Anteil des von der aktiven Schicht 32 in Richtung der Vorderseite emittierten Lichts durch die vorderseitige Oberfläche des Leuchtdiodenchips abgestrahlt werden. Bondpads haben in der Regel Abmessungen von mindestens 80 µm x 80 µm, um eine zuverlässige Befestigung eines Bonddrahts zu gewährleisten, und würden daher bei Leuchtdiodenchips 3 mit Abmessungen wie beim vorliegenden Ausführungsbeispiel einen großen Teil der vorderseitigen Oberfläche des Leuchtdiodenchips überdecken.

Auf die rückseitige, von der aktiven Schicht 32 abgewandte Oberfläche der p-leitenden Schicht 31 ist eine zweite Kontaktschicht 35 aufgebracht, die beispielsweise aus mindestens einem Metall wie Ag und/oder Au besteht.

Der vorderseitige Träger 1 weist eine Lichtauskoppelfläche 101 auf, durch die im Betrieb der Beleuchtungsvorrichtung von den Leuchtdiodenchips 3 emittiertes Licht ausgekoppelt wird. Zweckmäßigerweise besteht der vorderseitige Träger 1 aus einem lichtdurchlässigen Material wie Glas oder Kunststoff, zum Beispiel Polymethylmetacrylat (PMMA), Polycarbonat (PC) oder Polyethylenterephthalat (PET).

Der rückseitige Träger 2 ist vorliegend reflektierend und elektrisch leitfähig. Beispielsweise enthält er zumindest an seiner Vorderseite ein Metall. Alternativ kann auch der rückseitige Träger 2 zumindest stellenweise lichtdurchlässig ausgebildet sein. Auf diese Weise ist beispielsweise eine lichtdurchlässige, d.h. transluzente oder transparente Beleuchtungsvorrichtung erzielbar.

Der vorderseitige Träger 1 weist an einer vorderseitigen Bodenfläche jeder Vertiefung eine lichtdurchlässige elektrische Anschlussschicht 10 auf, welche zum Beispiel ein transparentes leitfähiges Oxid wie ITO oder ZnO:(Al,Ga) und/oder ein leitfähiges Polymer wie PEDOT:PSS aufweist oder aus mindestens einem dieser Materialien besteht. Vorliegend grenzt die elektrische Anschlussschicht 10 stellenweise direkt an den in der jeweiligen Vertiefung aufgenommenen Halbleiterchip 3 an. Insbesondere berühren sich die elektrische Anschlussschicht 10 und die erste Kontaktschicht 34 stellenweise.

An anderen Stellen sind die elektrische Anschlussschicht 10 und die erste Kontaktschicht 34 bei der Beleuchtungsvorrichtung gemäß dem vorliegenden Ausführungsbeispiel voneinander beabstandet. Der auf diese Weise gebildete Zwischenraum ist beispielsweise mit einem Brechungsindex-Anpassungsmaterial, beispielsweise einem sogenannten "Index-Matching Gel" auf Silikon-Basis, vollständig gefüllt. Insbesondere bildet die erste Kontaktschicht 34 einen Rahmen auf einem Randbereich der n-leitenden Schicht 33, der einen Mittelbereich der n-leitenden Schicht 33 frei lässt. Der Mittelbereich ist von dem Index-Matching Gel bedeckt.

Der vorderseitige Träger 1 ist zum Beispiel mit einer Schicht aus einem Klebstoff 4 an dem rückseitigen Träger befestigt. Die Leuchtdiodenchips 3 sind vorzugsweise in Draufsicht auf die Vorderseite und die der Vorderseite gegenüberliegende Rückseite der Beleuchtungsvorrichtung von dem Klebstoff 4 unbedeckt.
Beispielsweise ist mittels der Klebstoffschicht 4 eine Zugspannung zwischen dem vorderseitigen Träger 1 und dem rückseitigen Träger 2 erzielt. Mittels der Zugspannung können die Leuchtdiodenchips 3 an den vorderseitigen Träger 1 und an den rückseitigen Träger 2 gepresst sein. Auf diese Weise ist insbesondere ein stabiler mechanischer und elektrischer Kontakt zwischen der elektrischen Anschlussschicht 10 des vorderseitigen Trägers 1 und den ersten Kontaktschichten 34 der Leuchtdiodenchips 3 erzielt.

Ein stabiler mechanischer und elektrischer Kontakt zwischen dem rückseitigen Träger 2 und der zweiten Kontaktschicht 35 kann ebenfalls mittels der Zugspannung erzielt sein. Alternativ oder zusätzlich können die Leuchtdiodenchips 3 mit einem leitfähigen Klebstoff oder einem Lötmetall an dem rückseitigen Träger 2 befestigt und mit diesem elektrisch kontaktiert sein.

Die lateralen Abmessung L_{C} der Leuchtdiodenchips 3, der Abstand d_{C} benachbarter Leuchtdiodenchips 3 und der Abstand d_{L} zwischen den Leuchtdiodenchips 3 und der Lichtauskoppelfläche 101 sind so aneinander angepasst, dass im Betrieb der Beleuchtungseinrichtung die von den Leuchtdiodenchips 3 bei Ansteuerung mit der Nennleistung abgegebene Verlustwärme mittels natürlicher Konvektion an der Lichtauskoppelfläche 101 und einer rückseitigen, der Lichtauskoppelfläche 101 gegenüberliegenden Außenfläche 201 des rückseitigen Trägers 201 abgegeben wird, wobei die von den Leuchtdiodenchips 3 erzeugte Verlustwärme die Temperatur der Leuchtdiodenchips 3 um 60 K oder weniger gegenüber der Umgebungstemperatur erhöht und die Temperatur der Lichtauskoppelfläche 101 um 7 K oder mehr gegenüber der Umgebungstemperatur erhöht.
Die Lichtauskoppelfläche 101 und die rückseitige Außenfläche 201 stellen insbesondere Außenflächen der Beleuchtungsvorrichtung dar, die beispielsweise an Luft angrenzen. Die mittels natürlicher Konvektion an der Lichtauskoppelfläche 101 bzw. der rückseitigen Außenfläche 201 abgegebene Wärmeleistung beträgt zum Beispiel etwa 7 W pro Quadratmeter und pro Kelvin Temperaturunterschied zwischen der Umgebungstemperatur und der Temperatur der Lichtauskoppelfläche 101 bzw. der rückseitigen Außenfläche 201. Die Umgebungstemperatur ist dabei die Temperatur der Luft vor Inbetriebnahme der Beleuchtungsvorrichtung bzw. in großem Abstand von der Beleuchtungsvorrichtung.

Vorliegend beträgt der Abstand d_{L} zwischen den Leuchtdiodenchips 3 und der Lichtauskoppelfläche 101 der Beleuchtungsvorrichtung 4 mm. Die Bauhöhe H_{B} der Beleuchtungsvorrichtung beträgt beispielsweise 4,5 mm.

Der Abstand d_{C} zwischen einander unmittelbar benachbarten Leuchtdiodenchips beträgt vorliegend etwa 4 mm, so dass beispielsweise die Leuchtdioden 3 ein Array mit 75 x 75 Leuchtdioden und einer Gesamt-Nennleistung von etwa 10 W bilden. Die Temperaturerhöhung der Lichtauskoppelfläche 101 gegenüber der Umgebungstemperatur beträgt in diesem Fall etwa 10 K. Die Temperatur der Leuchtdiodenchips 3 ist beispielsweise um weniger als 20 K gegenüber der Umgebungstemperatur erhöht.

Der Abstand d_{C} zwischen einander unmittelbar benachbarten Leuchtdiodenchips 3 ist bei dem vorliegenden Ausführungsbeispiel mit 4 mm etwa genauso groß wie der Abstand d_{L} zwischen den Leuchtdiodenchips 3 und der Lichtauskoppelfläche 101 der Beleuchtungsvorrichtung. Die elektrische Leistungsaufnahme des von den 75 x 75 Leuchtdioden 3 mit einer Nennleistung von je 2 mW gebildeten Arrays beträgt, auf seine Grundfläche von 30 cm x 30 cm bezogen, etwa 125 W/m².

Die mittlere Leuchtdichte L beträgt bei dem Array gemäß dem vorliegenden Ausführungsbeispiel, das einen Raumwinkel von 2n mit einer Effizienz von etwa Φ/P= 115 lm/W bei einer Leistungsaufnahme von P/A = 125 W/m² beleuchtet, wobei die Leuchtdiodenchips 3 eine lambert'sche Abstrahlcharakteristik aufweisen, etwa L = (Φ/P * P/A)/π ≈ 4500 Cd/m². Im Fall von Leuchtdiodenchips mit isotroper Abstrahlung hätte die mittlere Leuchtdichte einen Wert von etwa 2000 Cd/m².

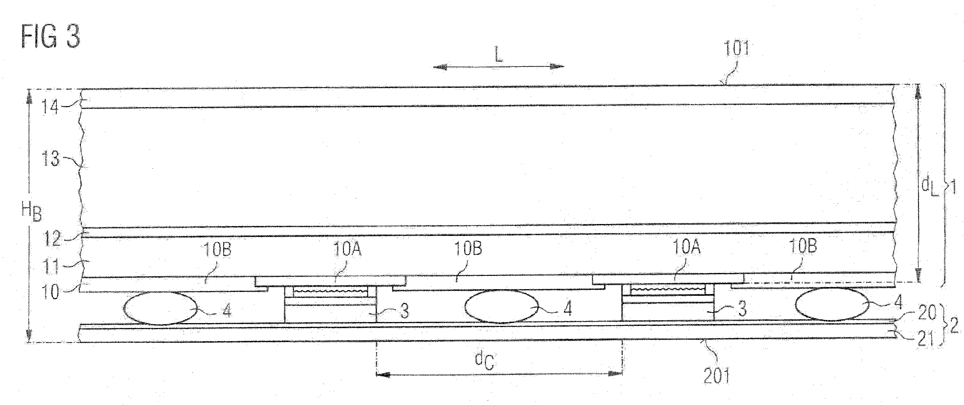

Figur 3 zeigt einen schematischen Querschnitt durch einen Ausschnitt einer Beleuchtungsvorrichtung gemäß einem zweiten exemplarischen Ausführungsbeispiel.

Bei dem zweiten Ausführungsbeispiel sind der vorderseitige Träger 1 und der rückseitige Träger im Gegensatz zum ersten Ausführungsbeispiel nicht bis auf die Leuchtdiodenchips 3 vollflächig verklebt. Stattdessen sind voneinander und von den Leuchtdiodenchips 3 beabstandete Klebepunkte 4 oder Klebelinien 4 zwischen den Leuchtdiodenchips 3 angeordnet.

Klebepunkte sind dabei insbesondere Klebstofftropfen, vorzugsweise mit vergleichsweise geringen Ausdehnungen in alle lateralen Richtungen. Klebelinien, auch Klebstoffraupen genannt, erstrecken sich im Wesentlichen entlang einer lateralen Richtung und haben eine geringe Ausdehnung in der dazu senkrechten lateralen Richtung.

Wie beim ersten Ausführungsbeispiel ist ein Klebstoff 4 verwendet, der beim Aushärten schrumpft, so dass sich das Volumen der Klebepunkte bzw. -linien 4 beim Aushärten des Klebstoffs während der Herstellung der Beleuchtungsvorrichtung - die insbesondere einen Laminier-Prozess umfasst - verringert. Auf diese Weise ist eine Zugspannung zwischen dem vorderseitigen Träger 1 und dem rückseitigen Träger 2 erzielt.
Im Gegensatz zum ersten Ausführungsbeispiel sind die Leuchtdiodenchips 3 nicht in Vertiefungen des vorderseitigen Trägers 1 aufgenommen. Vielmehr sind der vorderseitige und der rückseitige Träger 1, 2 jeweils im Wesentlichen planparallele Platten.

Der vorderseitige Träger 1 ist mittels der von den Klebepunkten oder -linien 4 erzeugten Zugspannung an die Leuchtdiodenchips 3 gepresst, so dass eine reibungs-basierte Arretierung der Leuchtdiodenchips 3 mit dem vorderseitigen Träger 1 ausgebildet ist. Mit dem rückseitigen Träger sind die Leuchtdiodenchips 3 vorliegend verlötet oder mit einem elektrisch leitfähigen Klebstoff verklebt. Die Lot- bzw. Klebstoffschicht zwischen den Leuchtdiodenchips 3 und dem rückseitigen Träger 2 ist in den Figuren zur Vereinfachung der Darstellung weggelassen.

Der vorderseitige Träger weist vorliegend einen Grundkörper 11, 12, 13, eine den Leuchtdiodenchips 3 zugewandte elektrische Anschlussschicht 10 und eine Auskoppelschicht 14 auf. Die Auskoppelschicht 14 enthält die Lichtauskoppelfläche 101 und begrenzt den vorderseitigen Träger 1 - und damit insbesondere die Beleuchtungsvorrichtung - in Richtung zur Vorderseite der Beleuchtungsvorrichtung hin. Die elektrische Anschlussschicht begrenzt den vorderseitigen Träger 1 in Richtung zu den Leuchtdiodenchips 3 hin.

Die elektrische Anschlussschicht 10 weist erste Teilstücke 10A auf, die analog zur elektrischen Anschlussschicht des ersten Ausführungsbeispiels lichtdurchlässig ausgebildet sind und beispielsweise ITO, ZnO:(Al,Ga) oder PEDOT:PSS enthalten. Die ersten Teilstücke 10A überlappen in Draufsicht auf die Vorderseite der Beleuchtungsvorrichtung jeweils mit einem der Leuchtdiodenchips 3. Sie grenzen stellenweise an die erste Kontaktschicht 34 des jeweiligen Leuchtdiodenchips 3 an, während an anderen Stellen ein Zwischenraum zwischen der ersten Kontaktschicht 34 und dem jeweiligen ersten Teilstück 10A mit einem Brechungsindex-Anpassungsmaterial, beispielsweise einem sogenannten "Index-Matching Gel" auf Silikon-Basis, vollständig gefüllt ist, wie in Zusammenhang mit dem ersten Ausführungsbeispiel beschrieben.

Bei dem vorliegenden Ausführungsbeispiel enthält die elektrische Anschlussschicht 10 des vorderseitigen Trägers 1 zusätzlich mindestens ein zweites Teilstück 10B, das beispielsweise mindestens zwei der ersten Teilstücke 10A elektrisch leitend miteinander verbindet. Beispielsweise überlappt das zweite Teilstück 10B mit einem Randbereich des jeweiligen ersten Teilstücks 10A. Das mindestens eine zweite Teilstück 10B stellt insbesondere eine Stromverteilungs-Schicht dar.

Das mindestens eine zweite Teilstück 10B kann alternativ oder zusätzlich eine elektrisch leitende Reflektorschicht 10B darstellen. Beispielsweise enthält es ein Metall mit einer hohen Reflektivität, etwa Ag. Bei einer Ausgestaltung überdeckt das bzw. überdecken die zweiten Teilstück(e) 10B in Draufsicht auf den vorderseitigen Träger 1 mindestens 50 %, vorzugsweise mindestens 70 %, besonders bevorzugt mindestens 85% der Lichtauskoppelfläche 101.
Bei einer Ausgestaltung ist die elektrische Anschlussschicht 10 vollflächig auf dem Grundkörper 11, 12, 13 aufgebracht. Bei einer anderen Ausgestaltung ist sie zur seriellen und/oder parallelen elektrischen Verschaltung der Leuchtdiodenchips 3 strukturiert. Die elektrische Anschlussschicht 10 hat beispielsweise eine Höhe, d.h. eine Ausdehnung in Richtung von der Vorderseite zur Rückseite, zwischen 20 µm und 200 µm, zum Beispiel zwischen 50 µm und 150 µm. Beispielsweise hat sie eine Höhe von etwa 100 µm. Es ist auch denkbar, dass die elektrische Anschlussschicht 10 eine Höhe von weniger als 20 µm aufweist. Solch geringe Dicken können beispielsweise vorteilhaft sein, wenn die Beleuchtungsvorrichtung biegsam und/oder lichtdurchlässig ausgebildet ist.

Der Grundkörper weist ein Trägerelement 11, eine Verbindungsschicht 12 und ein Lichtmischelement 13 auf oder besteht daraus. Der Grundkörper 11, 12, 13 des vorderseitigen Trägers 1 ist vorliegend lichtdurchlässig ausgebildet, insbesondere besteht der Grundkörper aus Materialien, die für das von den Leuchtdiodenchips 3 emittierte Licht durchlässig sind. Beispielsweise ist das Trägerelement 11 des vorderseitigen Trägers 1 von einer Kunststoffplatte oder -folie gebildet, die zum Beispiel Polyethylenterephthalat (PET) aufweist oder daraus besteht. Die Verbindungsschicht 12 enthält bei einer Ausgestaltung einen Klebstoff, der ein Silikon-Material enthält, oder besteht daraus. Das Lichtmischelement 13 enthält beispielsweise Glas, das bei einer Ausgestaltung SiO₂ enthält, und/oder PMMA oder besteht aus mindestens einem dieser Materialien.

Das Trägerelement 11 ist den Leuchtdiodenchips 3 zugewandt. Vorliegend ist die elektrische Anschlussschicht 10 direkt auf dem Trägerelement 11 ausgebildet. Beispielsweise hat das Trägerelement 11 eine Höhe zwischen 50 µm und 500 µm, vorzugsweise zwischen 100 µm und 200 µm, wobei die Grenzen jeweils eingeschlossen sind.

Das Lichtmischelement 13 ist an der von den Leuchtdiodenchips 3 abgewandten Seite mittels der Verbindungsschicht 12 an dem Trägerelement befestigt. Das Lichtmischelement 13 ist insbesondere dazu ausgebildet, einen Teil des von den Leuchtdiodenchips in Richtung zur Lichtauskoppelfläche 101 emittierten Lichts - zum Beispiel mittels Totalreflexion und/oder Streuung - umzulenken. Auf diese Weise stammt das an einer Stelle der Lichtauskoppelfläche 101 aus der Beleuchtungsrichtung ausgekoppelte Licht von mehreren - beispielsweise von drei oder mehr, insbesondere von fünf oder mehr - Leuchtdioden 3. So kann eine besonders homogene Leuchtdichteverteilung des von der Lichtauskoppelfläche 101 abgestrahlten Lichts erzielt werden. Das Lichtmischelement hat bei einer Ausgestaltung eine Höhe zwischen 2 mm und 6 mm, vorzugsweise zwischen 3 mm und 5 mm, wobei die Grenzen jeweils eingeschlossen sind. Vorliegend hat es eine Höhe von 4 mm.

Die Auskoppelschicht 14 kann beispielsweise von einem vorderseitigen Randbereich des Lichtmischelements 13 gebildet sein. Vorliegend ist sie jedoch als separate Schicht auf das Lichtmischelement 13 aufgebracht. Die vorderseitige Außenfläche der Auskoppelschicht 14 ist insbesondere von der Lichtauskoppelfläche 101 gebildet. Die Auskoppelschicht 14 ist zweckmäßigerweise mit Struktureinheiten versehen, welche dazu ausgebildet sind, die Lichtauskopplung gegenüber der Auskopplung aus einer planen Oberfläche zu verbessern. Beispielsweise handelt es sich bei den Struktureinheiten um Erhebungen und/oder Vertiefungen der Lichtauskoppelfläche 101. Derartige Strukturierungen sind dem Fachmann im Prinzip bekannt. Die Struktureinheiten haben bei einer Ausgestaltung Abmessungen in der Größenordnung einer oder mehrerer Wellenlängen des von den Leuchtdiodenchips 3 emittierten Lichts, zum Beispiel zwischen 50 nm und 5 µm, insbesondere zwischen 100 nm und 1 µm, wobei die Grenzen jeweils eingeschlossen sind.

Der rückseitige Träger 2 weist vorliegend eine den Leuchtdiodenchips 3 benachbarte Leiterbahn 20 und ein Trägerelement 21 auf. Die Leiterbahn 20 kann zur seriellen und/oder parallelen Verschaltung der Leuchtdiodenchips 3 strukturiert sein. Insbesondere stellt der rückseitige Träger eine Leiterplatte, beispielsweise eine gedruckte Leiterplatte (PCB, printed circuit board) dar. Der rückseitige Träger hat beispielsweise eine Höhe zwischen 50 µm und 200 µm, wobei die Grenzen eingeschlossen sind, vorliegend hat er eine Höhe von etwa 100 µm. Die Leiterbahn hat beispielsweise eine Höhe zwischen 5 µm und 20 µm, insbesondere zwischen 10 µm und 15 µm, wobei die Grenzen jeweils eingeschlossen sind. Auch Leiterbahnen mit geringeren Höhen sind denkbar und können vorteilhaft sein wenn die Beleuchtungsvorrichtung biegsam und/oder lichtdurchlässig ausgebildet ist.

Insgesamt hat die Beleuchtungsvorrichtung vorzugsweise eine Bauhöhe H_{B} zwischen 3 mm und 10 mm, vorzugsweise zwischen 4 mm und 6 mm, wobei die Grenzen jeweils eingeschlossen sind. Vorliegend hat die Bauhöhe H_{B} der Beleuchtungsvorrichtung einen Wert von etwa 4,5 mm.

Das Trägerelement 21 des rückseitigen Trägers 2 weist vorliegend wie das Trägerelement 11 des vorderseitigen Trägers 1 einen Kunststoff wie PET auf oder besteht daraus. Alternativ kann das Trägerelement 21 des rückseitigen Trägers 2 beispielsweise eine Edelstahl-Folie, etwa aus Edelstahl der Sorte V2A, aufweisen oder daraus bestehen. Ist das Trägerelement 21 des rückseitigen Trägers 2 elektrisch leitfähig, weist letzterer zweckmäßigerweise eine elektrische Isolationsschicht zwischen dem Trägerelement 21 und der Leiterbahn 20 auf. Bei einer Parallelschaltung der Leuchtdiodenchips 3 kann die Isolationsschicht entfallen. Eine weitere Isolationsschicht kann rückseitig auf das elektrisch leitfähige Trägerelement 21 aufgebracht sein.

Die Beleuchtungsvorrichtung gemäß dem zweiten Ausführungsbeispiel enthält zum Beispiel 225 Leuchtdiodenchips 3, die in Draufsicht auf die Vorderseite an den Gitterpunkten eines gedachten quadratischen Gitters angeordnet sind. Vorliegend sind alle Leuchtdiodenchips 3 parallel bestromt.
Die Leuchtdiodenchips 3 sind analog zu den in Zusammenhang mit Figur 2 beschriebenen Leuchtdiodenchips ausgebildet. Insbesondere haben sie beispielsweise eine quadratische Grundfläche mit einer Kantenlänge L_{C} von etwa 200 µm und eine Höhe H_{C} zwischen 5 µm und 15 µm, wobei die Grenzen eingeschlossen sind.

Die Nennleistung der Leuchtdiodenchips beträgt vorliegend etwa 45 mW. Die Beleuchtungsvorrichtung ist damit zum Betrieb mit einer Leistungsaufnahme von 10 W vorgesehen. Beispielsweise wird im Betrieb der Beleuchtungsvorrichtung ein Lichtstrom von 1000 Im von der Lichtauskoppelfläche 101 abgestrahlt. Anders ausgedrückt haben die Leuchtdiodenchips 3 vorliegend eine Lichtausbeute von 100 lm/W.

Ein Teil der Verlustwärme wird an der Lichtauskoppelfläche 101 von der Beleuchtungsvorrichtung an die Umgebung, insbesondere an die die Beleuchtungsvorrichtung umgebende Luft abgegeben. Ein weiterer Teil der von den Leuchtdiodenchips 3 im Betrieb emittierten Verlustwärme wird von einer rückseitigen Außenfläche 201 des im Wesentlichen planen rückseitigen Trägers 2 aus der Beleuchtungsvorrichtung abgeführt. Vorzugsweise beinhaltet die Abführung der Verlustwärme an der Lichtauskoppelfläche 101 und an der rückseitigen Außenfläche 201 Wärmeabgabe mittels natürlicher Konvektion.

Beispielsweise mittels der Leiterbahn 20 oder mittels der Leiterbahn 20 und dem Trägerelement 21 wird eine Wärmespreizung erzielt. Die geringen lateralen Abmessungen L_{C} der Leuchtdiodenchips 3 tragen dazu bei, dass pro Leuchtdiodenchip 3 vergleichsweise wenig Verlustwärme abgegeben und damit eine besonders gleichmäßige laterale Verteilung der von den Leuchtdiodenchips gebildeten Wärmequellen erzielt werden kann. Auf diese Weise kann die Verlustwärme besonders gut von den einzelnen Leuchtdiodenchips 3 abgeführt und besonders gleichmäßig über die Lichtauskoppelfläche 101 und die rückseitige Außenfläche 201 des rückseitigen Trägers 2 verteilt werden.

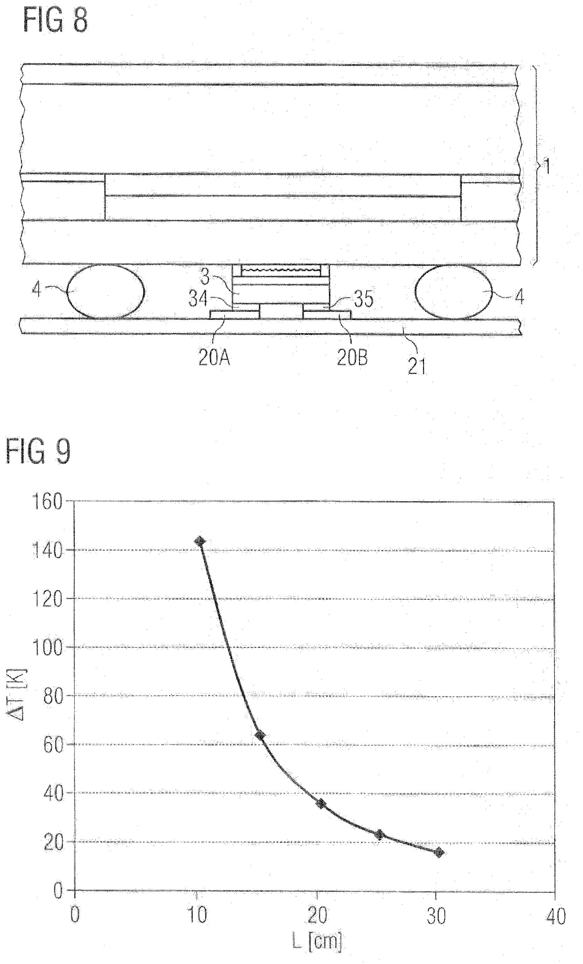

Figur 9 zeigt ein Diagramm der Temperaturerhöhung ΔT der Lichtauskoppelfläche 101 in Kelvin in Abhängigkeit von ihrer Kantenlänge L bei der Beleuchtungsvorrichtung gemäß dem zweiten Ausführungsbeispiel. In Figur 3, die einen Ausschnitt der Beleuchtungsvorrichung zeigt, ist die Richtung der Kantenlänge L der Lichtauskoppelfläche 101 durch einen Pfeil angedeutet.
Die Temperaturerhöhung ΔT wurde für die Abgabe einer Wärmeleistung von 7 W/(m²K) mittels natürlicher Konvektion an der Grenzfläche zwischen der Lichtauskoppelfläche 101 und der umgebenden Luft bei einer Lichtauskoppelfläche 101 mit quadratischer Kontur in Abhängigkeit von der Kantenlänge L der Lichtauskoppelfläche 101 berechnet. Die Entwärmung der Beleuchtungsvorrichtung über die rückseitige Außenfläche 201 des rückseitigen Trägers 2 ist dabei vernachlässigt.

Bei einer Kantenlänge L von 15 cm, entsprechend einem Abstand d_{C} benachbarter Leuchtdiodenchips 3 von 10 mm, hat die Temperaturerhöhung ΔT der Lichtauskoppelfläche 101 gegenüber der Umgebungstemperatur einen Wert von 63,5 K, d.h. von weniger als 65 K und von mehr als 7 K.

Bei einer kleineren Kantenlänge L als 15 cm ist die Temperaturerhöhung ΔT der Lichtauskoppelfläche 101 und damit auch der Leuchtdiodenchips 3 gegenüber der Umgebungstemperatur stärker, so dass die Gefahr einer Verringerung von Lebensdauer und Effizienz der Leuchtdiodenchips 3 erhöht ist. Bei größeren Kantenlängen L sinkt die Temperaturerhöhung ΔT ab, zum Beispiel auf einen Wert von etwa 36 K bei einer Kantenlänge L von 20 cm, von etwa 23 K bei einer Kantenlänge L von 25 cm und von etwa 16 K bei einer Kantenlänge L von 30 cm.

Bei einer Kantenlänge L der Lichtauskoppelfläche von 15 cm, welche der Kantenlänge des Arrays von Leuchtdioden 3 entspricht, beträgt die elektrische Leistungsaufnahme pro Fläche bei der Beleuchtungsvorrichtung gemäß dem vorliegenden Ausführungsbeispiel im Flächenmittel 445 W/m², sie ist mithin geringer als 450 W/m². Die mittlere Leuchtdichte beträgt in diesem Fall in Draufsicht auf die Lichtauskoppelfläche, entsprechend einem beleuchteten Raumwinkel von 2n, und bei der Effizienz von 100 lm/W etwa 14000 Cd/m² bei lambert'scher Abstrahlcharakteristik der Leuchtdiodenchips 3 und etwa 7000 Cd/m² bei isotroper Abstrahlcharakteristik der Leuchtdiodenchips 3. Mithin ist sie größer als 2000 Cd/m².

Der Abstand d_{L} zwischen der Lichtauskoppelfläche 101 und den Leuchtdiodenchips 3 beträgt bei der Beleuchtungsvorrichtung gemäß dem zweiten Ausführungsbeispiel zum Beispiel etwa 4,3 mm. Der Abstand d_{C} benachbarter Leuchtdiodenchips 3 von 10 mm bei einer Kantenlänge L der quadratischen Lichtauskoppelfläche 101 von 15 cm ist damit kleiner als das 2,5-fache des Abstands d_{L}. Bei einer Kantenlänge L der Lichtauskoppelfläche von beispielsweise über 25 cm und der gleichen Anzahl an Leuchtdiodenchips 3 steigt der entsprechende Abstand d_{C} über das 2,5-fache des Abstands d_{L} an. Bei größeren Kantenlängen L als 25 cm kann die Gefahr einer unzureichenden Homogenität des von der Lichtauskoppelfläche 101 abgestrahlten Lichts bestehen.

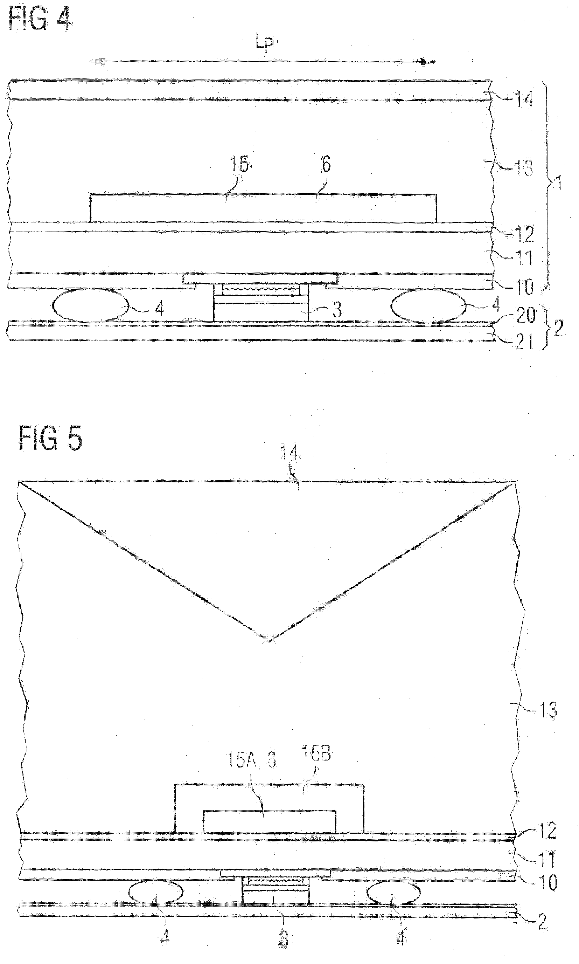

Figur 4 zeigt einen schematischen Querschnitt durch einen Ausschnitt einer Beleuchtungsvorrichtung gemäß einem dritten exemplarischen Ausführungsbeispiel.

Die Beleuchtungsvorrichtung des dritten Ausführungsbeispiels entspricht im Wesentlichen derjenigen des zweiten Ausführungsbeispiels. Zusätzlich weist sie jedoch eine Mehrzahl von Lumineszenzkonversionselementen 6 auf. Die Lumineszenzkonversionselemente enthalten einen - vorzugsweise anorganischen - Leuchtstoff wie beispielsweise YAG:Ce. Der Leuchtstoff ist dazu ausgebildet, von den Leuchtdiodenchips 3 emittiertes Licht (Primärlicht) - zum Beispiel blaues Primärlicht - in Sekundärlicht einer anderen Wellenlänge - zum Beispiel einer Wellenlänge aus dem grünen, gelben oder roten Spektralbereich - zu konvertieren. Bei einer Ausgestaltung transmittieren die Lumineszenzkonversionselemente 6 einen Teil des Primärlichts, so dass die Beleuchtungseinrichtung Mischlicht aus Primärlicht der Leuchtdiodenchips 3 und Sekundärlicht der Lumineszenzkonversionselemente 6 abstrahlt. Alternativ absorbieren die Konversionselemente das Primärlicht vollständig oder nahezu vollständig, so dass die Beleuchtungsvorrichtung insbesondere Licht mit dem Emissionsspektrum des vom Leuchtstoff emittierten Sekundärlichts abstrahlt.

Die einzelnen Lumineszenzkonversionselemente sind in voneinander lateral beabstandeten Kavitäten 15 des vorderseitigen Trägers 1 angeordnet. Würden stattdessen Leuchtdiodenchips 3 benutzt, die selbst die Lumineszenzkonversionselemente enthalten, wären die von den Leuchtdiodenchips 3 umfassten Lumineszenzkonversionselemente bei der vorliegenden Beleuchtungseinrichtung beispielsweise rückseitig von der elektrischen Anschlussschicht 10 angeordnet. Eine solche Anordnung wäre wegen der besonderen Art der Chipmontage und Chipkontaktierung zwischen dem vorderseitigen und dem rückseitigen Träger 1, 2 bei der Beleuchtungsvorrichtung gemäß dem vorliegenden Ausführungsbeispiel weniger gut geeignet.
Beispielsweise weist das Lichtmischelement 13 an seiner rückseitigen Oberfläche Vertiefungen auf, die mit einer den Leuchtstoff enthaltenden Vergussmasse vollständig gefüllt sind, um die Lumineszenzkonversionselemente 6 zu bilden. Die Füllung der Vertiefungen erfolgt beispielsweise mittels eines Rakel-Prozesses bei der Herstellung des vorderseitigen Trägers 1.

Jedes Lumineszenzkonversionselement 6 ist einem der Leuchtdiodenchips 3 zugeordnet und überlappt in Draufsicht auf die Vorderseite der Beleuchtungsvorrichtung mit jeweiligen Leuchtdiodenchip 3. Insbesondere überdeckt es den Leuchtdiodenchip vollständig, d.h. die lateralen Abmessungen Lp des jeweiligen Lumineszenzkonversionselements 6 sind größer oder gleich den lateralen Abmessungen L_{C} des Leuchtdiodenchips 3. Vorzugsweise sind die lateralen Abmessungen Lp des Lumineszenzkonversionselements 6 zwei- bis dreimal so groß wie die lateralen Abmessungen L_{C} des Leuchtdiodenchips 3, wobei die Grenzen eingeschlossen sind.

Figur 5 zeigt einen schematischen Querschnitt durch einen Ausschnitt einer Beleuchtungsvorrichtung gemäß einem vierten exemplarischen Ausführungsbeispiel.

Dieses unterscheidet sich zunächst dadurch vom dritten Ausführungsbeispiel, dass die Kavitäten 15 jeweils einen ersten Teilbereich 15A aufweisen, der das Lumineszenzkonversionselement 6 enthält, und einen zweiten Teilbereich 15B aufweisen, der frei von dem Lumineszenzkonversionselement 6 ist und dem ersten Teilbereich 15A zumindest in Richtung zur Lichtauskoppelfläche 101 hin nachfolgt.

Der erste Teilbereich 15A und das Lumineszenzkonversionselement 6 überdecken den Leuchtdiodenchip vollständig, d.h. die lateralen Abmessungen Lp des jeweiligen Lumineszenzkonversionselements 6 und des ersten Teilbereichs 15A sind größer oder gleich den lateralen Abmessungen L_{C} des Leuchtdiodenchips 3 und vorzugsweise zwei- bis dreimal so groß wie die lateralen Abmessungen L_{C} des Leuchtdiodenchips 3, wobei die Grenzen eingeschlossen sind.

Der zweite Teilbereich 15B ist mit einem Gas, insbesondere mit Luft, gefüllt. Das Gas hat einen niedrigeren Brechungsindex, als das Material des Lichtmischelements 13, welches die Kavität 15 - und insbesondere deren zweiten Teilbereich 15B - in Richtung zur Lichtauskoppelfläche 101 hin begrenzt.

Weiterhin im Unterschied zu den vorhergehenden Ausführungsbeispielen wird die Auskoppelschicht 14 von einem vorderseitigen Randbereich des Lichtmischelements 13 gebildet. Sie weist Struktureinheiten auf, deren Größenordnung im Bereich der lateralen Abmessungen L_{C} der Leuchtdiodenchips 3 liegt. Jede der Struktureinheiten überdeckt einen Leuchtdiodenchip 3 zum Beispiel teilweise oder vollständig.

Vorliegend handelt es sich bei den Struktureinheiten um Vertiefungen, die dazu vorgesehen sind einen Teil des von den Leuchtdiodenchips 3 emittierten Primärlichts und/oder einen Teil des von den Lumineszenzkonversionselementen 6 emittierten Sekundärlichts mittels Totalreflexion umzulenken. Solche Vertiefungen sind dem Fachmann beispielsweise grundsätzlich aus der Druckschrift US 6,473,554 B1 bekannt, deren Offenbarungsgehalt - insbesondere hinsichtlich der Formgebung und Anordnung der Vertiefungen - hiermit durch Rückbezug in die vorliegende Offenbarung aufgenommen wird. Mit solchen Struktureinheiten ist vorteilhafterweise eine besonders gute Lichtmischung im Lichtmischelement 13 und eine besonders geringe Bauhöhe H_{B} der Beleuchtungsvorrichtung erzielbar.

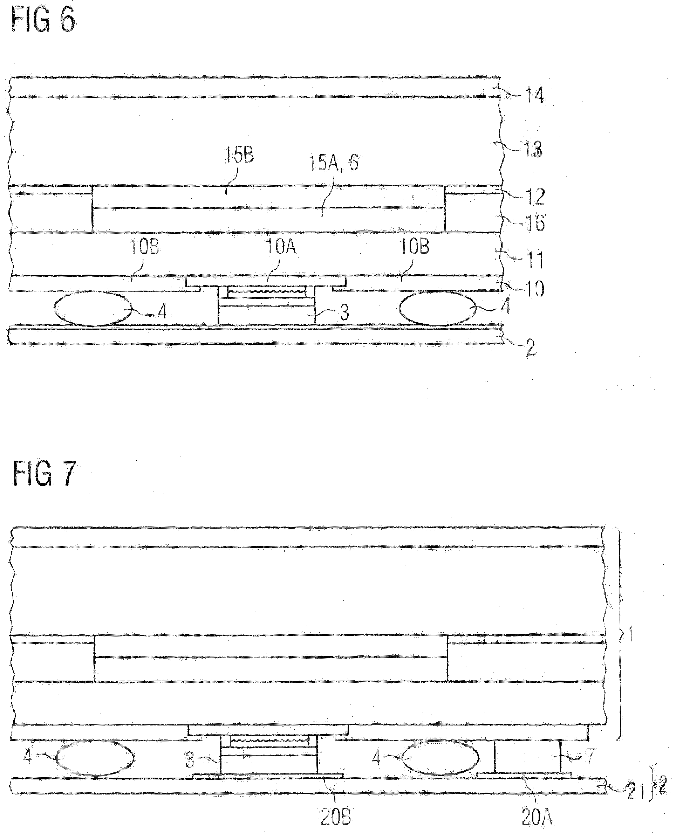

Figur 6 zeigt einen schematischen Querschnitt durch einen Ausschnitt einer Beleuchtungsvorrichtung gemäß einem fünften exemplarischen Ausführungsbeispiel.

Dieses unterscheidet sich vom vierten Ausführungsbeispiel zunächst dadurch, dass die Auskoppelschicht 14 wie beim zweiten Ausführungsbeispiel ausgebildet ist. Zudem sind die erste Teilbereiche 15A der Kavitäten 15 nicht von den jeweiligen zweiten Teilbereichen 15B seitlich umschlossen. Vielmehr füllen die ersten Teilbereiche 15A - und damit die Lumineszenzkonversionselemente 6 - die jeweilige Kavität 15 in lateraler Richtung vollständig aus.

Schließlich weisen die zweiten Teilstücke 10B der elektrischen Anschlussschicht 10 des vorderseitigen Trägers Al anstelle von Ag auf und der vorderseitige Träger 1 enthält eine Licht streuende und diffus reflektierende Schicht 16. Auf eine mit der elektrischen Anschlussschicht 10 integriert ausgebildete Ag-Reflektorschicht, bei der die Gefahr einer Beeinträchtigung durch Oxidation bestehen kann, ist auf diese Weise mit Vorteil verzichtet.

Die Licht streuende und diffus reflektierende Schicht 16 ist zwischen dem Trägerelement 11 und dem Lichtmischelement 13 angeordnet. Vorliegend sind die Kavitäten 15 des vorderseitigen Trägers 1 lateral von der diffus reflektierenden Schicht 16 begrenzt. Die Licht streuende und diffus reflektierende Schicht 16 weist beispielsweise TiO₂ Partikel auf, die in einer Matrix aus einem Silikon-Material eingebettet sind.

Figur 7 zeigt einen schematischen Querschnitt durch einen Ausschnitt einer Beleuchtungsvorrichtung gemäß einem sechsten exemplarischen Ausführungsbeispiel.

Dieses unterscheidet sich vom fünften Ausführungsbeispiel dadurch, dass Brückenelemente 7 zwischen dem vorderseitigen Träger 1 und dem rückseitigen Träger 2 angeordnet sind. Die Brückenelemente 7 haben beispielsweise die gleiche Höhe H_{C} wie die Leuchtdiodenchips 3 und sind in gleicher Weise wie diese von den Trägern 1, 2 arretiert bzw. befestigt. In lateraler Richtung sind die Brückenelemente 7 zum Beispiel zwischen den Leuchtdiodenchips 3 angeordnet. Beispielsweise handelt es sich bei den Brückenelementen 7 um Metallblöcke, um dotierte Siliziumblöcke oder um metallbeschichtete Kunststoffblöcke. Auf diese Weise sind die Leuchtdiodenchips 3 beispielsweise frei verdrahtbar.

Der rückseitige Träger 2 weist vorliegend mindestens eine erste Leiterbahn 20A auf, die zur vorderseitigen Kontaktierung der Leuchtdiodenchips mittels der Brückenelemente 7 elektrisch leitend mit der - insbesondere strukturierten - elektrischen Anschlussschicht 10 des vorderseitigen Trägers 1 verbunden ist. Mindestens eine zweite elektrische Leiterbahn 20B des rückseitigen Trägers ist zur rückseitigen Kontaktierung der Leuchtdiodenchips 3 vorgesehen. Vorzugsweise sind die Leuchtdiodenchips 3 auf der/den zweiten elektrischen Leiterbahn(en) 20B befestigt und die Brückenelemente 7 sind auf der/den ersten elektrischen Leiterbahn(en) 20A befestigt.

Figur 8 zeigt einen schematischen Querschnitt durch einen Ausschnitt einer Beleuchtungsvorrichtung gemäß einem siebten exemplarischen Ausführungsbeispiel.

Bei diesem Ausführungsbeispiel sind die Leuchtdiodenchips 3 sowohl zur n-seitigen als auch zur p-seitigen Kontaktierung von der Rückseite her ausgebildet. Beispielsweise sind die erste und die zweite elektrische Kontaktschicht 34, 35 - oder zumindest Teilstücke derselben - rückseitig auf die lichterzeugende Halbleiterschichtenfolge 31, 32, 33 aufgebracht. Zweckmäßigerweise ist die erste Kontaktschicht 34 durch die aktive Schicht 32 hindurch geführt. Solche Leuchtdiodenchips 3 sind dem Fachmann beispielsweise grundsätzlich aus der Druckschrift WO 2008/131735 A1 bekannt, deren Offenbarungsgehalt insofern hiermit durch Rückbezug in die vorliegende Offenbarung aufgenommen wird. Auch Leuchtdioden vom sogenannten "Flip Chip"-Typ, die dem Fachmann ebenfalls grundsätzlich bekannt sind, und daher an dieser Stelle nicht näher erläutert werden, sind für die Beleuchtungsvorrichtung gemäß dem vorliegenden Ausführungsbeispiel geeignet.
Die elektrische Kontaktierung der Leuchtdiodenchips erfolgt bei diesem Ausführungsbeispiel mittels der ersten und zweiten Leiterbahn(en) 20A, 20B des rückseitigen Trägers, wobei beispielsweise jeder Leuchtdiodenchip 3 mit einer ersten und einer zweiten Leiterbahn 20A, 20B überlappt. Der vorderseitige Träger 1 weist bei dem vorliegenden Ausführungsbeispiel insbesondere keine elektrische Anschlussschicht auf.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Beleuchtungsvorrichtung mit einem vorderseitigen Träger (1), einem rückseitigen Träger (2) und einer Mehrzahl von Leuchtdiodenchips (3), die im Betrieb der Beleuchtungsvorrichtung Licht emittieren und Verlustwärme abgeben, wobei
- der rückseitige Träger (2) zumindest stellenweise von dem vorderseitigen Träger (1) bedeckt ist,
- die Leuchtdiodenchips (3) so zwischen dem rückseitigen Träger (2) und dem vorderseitigen Träger (1) angeordnet sind, dass sie ein Array bilden,
- die Leuchtdiodenchips (3) mittels des rückseitigen und/oder des vorderseitigen Trägers (1, 2) elektrisch kontaktiert und von dem rückseitigen Träger (2) und dem vorderseitigen Träger (1) mechanisch arretiert sind, und
- der vorderseitige Träger (1) wärmeleitend an die Leuchtdiodenchips (3) gekoppelt ist und eine von den Leuchtdiodenchips (3) abgewandte Lichtauskoppelfläche (101) aufweist, die zur Abgabe eines Teils der von den Leuchtdiodenchips (3) abgegebenen Verlustwärme an die Umgebung ausgebildet ist,
**dadurch gekennzeichnet, dass**
- jeder Leuchtdiodenchip (3) zur Ansteuerung mit einer elektrischen Nennleistung von 100 mW oder weniger im Betrieb der Beleuchtungsvorrichtung vorgesehen ist und eine Lichtausbeute von 100 lm/W oder mehr hat,
- die Abstände (d_{C}) zwischen einander benachbarten Leuchtdiodenchips (3) so groß gewählt sind, dass im Betrieb der Beleuchtungsvorrichtung bei Ansteuerung der Leuchtdiodenchips (3) mit der elektrischen Nennleistung das von den Leuchtdiodenchips (3) gebildete Array bezogen auf seine Grundfläche eine elektrische Leistungsaufnahme von kleiner oder gleich 450 W/m² hat, und
- die Abstände (d_{C}) zwischen einander benachbarten Leuchtdiodenchips (3) so klein gewählt sind, dass im Betrieb der Beleuchtungsvorrichtung bei Ansteuerung der Leuchtdiodenchips (3) mit der elektrischen Nennleistung das von den Leuchtdiodenchips (3) gebildete Array in Draufsicht auf die Lichtauskoppelfläche Licht mit einer mittleren Leuchtdichte von größer oder gleich 2000 Cd/m² emittiert und die Abstände (d_{C}) kleiner oder gleich dem 2,5-fachen eines Abstands (d_{L}) zwischen der Lichtauskoppelfläche (101) und den Leuchtdiodenchips (3) sind.

2. Beleuchtungsvorrichtung gemäß Anspruch 1, wobei der Abstand (d_{L}) zwischen der Lichtauskoppelfläche (101) und den Leuchtdiodenchips (3) kleiner oder gleich 5 mm ist.

3. Beleuchtungsvorrichtung gemäß einem der vorhergehenden Ansprüche, wobei die Leuchtdiodenchips (3) laterale Abmessungen (L_{C}) von 300 µm oder weniger haben.

4. Beleuchtungsvorrichtung gemäß einem der vorhergehenden Ansprüche, die zur Entwärmung ohne zusätzlichen Kühlkörper mittels Wärmeabgabe an der Lichtauskoppelfläche (101) und an einer rückseitigen Außenfläche (201) des rückseitigen Trägers (2) ausgebildet ist.

5. Beleuchtungsvorrichtung gemäß einem der vorhergehenden Ansprüche, wobei der vorderseitige und der rückseitige Träger (1, 2) biegsam sind.

6. Beleuchtungsvorrichtung gemäß einem der vorhergehenden Ansprüche, deren Bauhöhe (H_{B}) kleiner oder gleich 10 mm, insbesondere kleiner oder gleich 5 mm, ist.

7. Beleuchtungsvorrichtung gemäß einem der vorhergehenden Ansprüche, wobei zwischen dem vorderseitigen Träger (1) und dem rückseitigen Träger (2) stellenweise ein Haftvermittlungsmaterial (4) angeordnet ist, mittels welchem eine Zugspannung zwischen den Trägern (1, 2) erzielt ist.

8. Beleuchtungsvorrichtung gemäß einem der vorhergehenden Ansprüche, wobei zwischen den Leuchtdiodenchips (3) und dem vorderseitigen Träger (1) ein Brechungsindex-Anpassungsmaterial (5) angeordnet ist.

9. Beleuchtungsvorrichtung gemäß einem der vorhergehenden Ansprüche, wobei der vorderseitige Träger (1) eine Mehrzahl voneinander getrennter Kavitäten (15) umschließt, wobei jede Kavität (15) mit einem der Leuchtdiodenchips (3) überlappt und ein Lumineszenzkonversionselement (6) mit einem Leuchtstoff enthält.

10. Beleuchtungsvorrichtung gemäß einem der Ansprüche 1 bis 8, wobei der vorderseitige Träger (1) eine Mehrzahl voneinander getrennter Kavitäten (15) umschließt, wobei
- jede Kavität (15) mit einem der Leuchtdiodenchips (3) überlappt,
- ein erster, dem jeweiligen Leuchtdiodenchip (3) zugewandter Teilbereich (15A) jeder Kavität (15) ein Lumineszenzkonversionselement (6) mit einem Leuchtstoff enthält und
- ein zweiter, von dem jeweiligen Leuchtdiodenchip (3) abgewandter Teilbereich (15B) jeder Kavität (15) mit einem Material, insbesondere einem Gas, gefüllt ist, das einen niedrigeren Brechungsindex hat, als das Material des vorderseitigen Trägers (1), welches die Kavität (15) in Richtung zur Lichtauskoppelfläche (101) hin begrenzt, und insbesondere eine gekrümmte Oberfläche aufweist.

11. Beleuchtungsvorrichtung gemäß einem der Ansprüche 9 oder 10, wobei jede Kavität (15) laterale Abmessungen (Lp) hat, die jeweils kleiner oder gleich dem dreifachen der entsprechenden lateralen Abmessung (L_{C}) des Leuchtdiodenchips (3) sind, mit dem die Kavität (15) überlappt.

12. Beleuchtungsvorrichtung gemäß einem der vorhergehenden Ansprüche, wobei der vorderseitige Träger (1) eine mittels Streupartikeln diffus reflektierende Schicht (16) enthält.

13. Beleuchtungsvorrichtung gemäß einem der vorhergehenden Ansprüche, wobei die Leuchtdiodenchips (3) jeweils eine dem vorderseitigen Träger (1) zugewandte lichtdurchlässige Kontaktschicht (34) aufweisen, und der vorderseitige Träger (1) eine zumindest stellenweise lichtdurchlässige elektrische Anschlussschicht (10) aufweist, welche insbesondere direkt an die Kontaktschichten (34) der Leuchtdiodenchips (3) angrenzt.

14. Beleuchtungsvorrichtung gemäß Anspruch 13, wobei der rückseitige Träger (2) mindestens eine Leiterbahn (20A) aufweist, die zur vorderseitigen elektrischen Kontaktierung mindestens eines der Leuchtdiodenchips (3) vorgesehen ist, und mindestens ein elektrisches Brückenelement (7) zwischen dem vorderseitigen Träger (1) und dem rückseitigen Träger (2) angeordnet ist, das einen elektrischen Kontakt zwischen der Leiterbahn (20A) des rückseitigen Trägers und der elektrischen Anschlussschicht (10) des vorderseitigen Trägers (1) herstellt.

15. Beleuchtungseinrichtung gemäß Anspruch 14, wobei die Leuchtdiodenchips (3) und das elektrische Brückenelement (7) etwa die gleiche Höhe (H_{C}) haben.

## Claims

1. Lighting device with a front carrier (1), a rear carrier (2) and a plurality of light-emitting diode chips (3), which when the lighting device is in operation emit light and release waste heat, wherein
- the rear carrier (2) is covered at least in places by the front carrier (1),
- the light-emitting diode chips (3) are arranged in such a way between the rear carrier (2) and the front carrier (1) that they form an array,
- the light-emitting diodes (3) are contacted electrically by means of the rear and/or of the front carrier (1, 2) and immobilised mechanically by the rear carrier (2) and the front carrier (1), and
- the front carrier (1) is coupled thermally conductively to the light-emitting diode chips (3) and comprises a light outcoupling face (101) remote from the light-emitting diode chips (3), which light outcoupling face is constructed to release some of the waste heat released by the light-emitting diode chips (3) into the surrounding environment,
**characterized in that**
- each light-emitting diode chip (3) is provided for actuation with an electrical nominal power of 100 mW or less when the lighting device is in operation and has a light yield of 100 lm/W or more,
- the distances (d_{C}) between mutually adjacent light-emitting diode chips (3) are selected to be sufficiently large for the array formed by the light-emitting diode chips (3) to have an electrical power consumption relative to its base, on actuation of the light-emitting diode chips (3) with the electrical nominal power, of less than or equal to 450 W/m², when the lighting device is in operation, and
- the distances (d_{C}) between mutually adjacent light-emitting diode chips (3) are selected to be sufficiently small for the array formed by the light-emitting diode chips (3) to emit light, in plan view onto the light outcoupling face, with an average luminance of greater than or equal to 2000 Cd/m², on actuation of the light-emitting diode chips (3) with the electrical nominal power when the lighting device is in operation and the distances (d_{C}) are less than or equal to 2.5 times a distance (d_{L}) between the light outcoupling face (101) and the light-emitting diode chips (3).

2. Lighting device according to claim 1, wherein the distance (d_{L}) between the light outcoupling face (101) and the light-emitting diode chips (3) is less than or equal to 5 mm.

3. Lighting device according to any one of the preceding claims, wherein the light-emitting diode chips (3) have lateral dimensions (L_{C}) of 300 µm or less.

4. Lighting device according to any one of the preceding claims, which is designed for cooling without an additional heat sink by means of heat release at the light outcoupling face (101) and at a rear outer face (201) of the rear carrier (2).

5. Lighting device according to any one of the preceding claims, wherein the front and the rear carriers (1, 2) are flexible.

6. Lighting device according to any one of the preceding claims, whose structural height (H_{B}) is less than or equal to 10 mm, in particular less than or equal to 5 mm.

7. Lighting device according to any one of the preceding claims, wherein an adhesion-promoting material (4) is arranged in places between the front carrier (1) and the rear carrier (2), by means of which material a tensile stress is achieved between the carriers (1, 2).

8. Lighting device according to any one of the preceding claims, wherein a refractive index matching material (5) is arranged between the light-emitting diode chips (3) and the front carrier (1).

9. Lighting device according to any one of the preceding claims, wherein the front carrier (1) encloses a plurality of mutually separate cavities (15), wherein each cavity (15) overlaps with one of the light-emitting diode chips (3) and contains a luminescence conversion element (6) with a luminescent material.

10. Lighting device according to any one of claims 1 to 8, wherein the front carrier (1) encloses a plurality of mutually separate cavities (15), wherein
- each cavity (15) overlaps with one of the light-emitting diode chips (3),
- a first sub-region (15A) of each cavity (15) facing the respective light-emitting diode chip (3) contains a luminescence conversion element (6) with a luminescent material and
- a second sub-region (15B) of each cavity (15) remote from the respective light-emitting diode chip (3) is filled with a material, in particular a gas, which has a lower refractive index than the material of the front carrier (1), which delimits the cavity (15) towards the light outcoupling face (101), and in particular comprises a curved surface.

11. Lighting device according to either one of claims 9 or 10, wherein each cavity (15) has lateral dimensions (L_{P}) which are in each case less than or equal to three times the corresponding lateral dimension (L_{C}) of the light-emitting diode chip (3) with which the cavity (15) overlaps.

12. Lighting device according to any one of the preceding claims, wherein the front carrier (1) contains a layer (16) which reflects diffusely by means of scattering particles.

13. Lighting device according to any one of the preceding claims, wherein the light-emitting diode chips (3) each comprise a light-transmitting contact layer (34) facing the front carrier (1), and the front carrier (1) comprises an electrical connection layer (10) which transmits light at least in places, which connection layer in particular directly adjoins the contact layers (34) of the light-emitting diode chips (3).

14. Lighting device according to claim 13, wherein the rear carrier (2) comprises at least one conductor track (20A), which is provided for front electrical contacting of at least one of the light-emitting diode chips (3), and at least one electrical bridge element (7) is arranged between the front carrier (1) and the rear carrier (2), which produces electrical contact between the conductor track (20A) of the rear carrier and the electrical connection layer (10) of the front carrier (1).

15. Lighting device according to claim 14, wherein the light-emitting diode chips (3) and the electrical bridge element (7) are of roughly the same height (H_{C}).

## Revendications

1. Dispositif d'éclairage présentant un support avant (1), un support arrière (2) et une pluralité de puces (3) de diode électroluminescente, qui émettent de la lumière et de la chaleur perdue lors du fonctionnement du dispositif d'éclairage,
- le support arrière (2) étant au moins partiellement recouvert par le support avant (1),
- les puces (3) de diode électroluminescente étant disposées entre le support arrière (2) et le support avant (1) de manière telle qu'elles forment un réseau,
- les puces (3) de diode électroluminescente étant en contact électrique au moyen du support arrière et/ou avant (1, 2) et bloquées mécaniquement par le support arrière (2) et le support avant (1) et
- le support avant (1) étant couplé de manière à conduire la chaleur aux puces (3) de diode électroluminescente et présentant une surface de découplage de la lumière (101), opposée aux puces (3) de diode électroluminescente, qui est réalisée pour transmettre une partie de la chaleur perdue émise par les puces (3) de diode électroluminescente à l'environnement,
**caractérisé en ce que**
- chaque puce (3) de diode électroluminescente est prévue pour une excitation par une puissance nominale électrique de 100 mW ou moins lors du fonctionnement du dispositif d'éclairage et présente un rendement lumineux de 100 lm/W ou plus,
- les distances (d_{C}) entre des puces (3) de diode électroluminescente adjacentes sont tellement grandes que lors du fonctionnement du dispositif d'éclairage, lors de l'excitation des puces (3) de diode électroluminescente par la puissance nominale électrique, le réseau formé par les puces (3) de diode électroluminescente présente une puissance électrique absorbée, par rapport à sa surface de base, inférieure ou égale à 450 W/m², et
- les distances (d_{C}) entre des puces (3) de diode électroluminescente adjacentes sont tellement petites que lors du fonctionnement du dispositif d'éclairage, lors de l'excitation des puces (3) de diode électroluminescente par la puissance nominale électrique, le réseau formé par les puces (3) de diode électroluminescente émet, en vue du dessus sur la surface de découplage de la lumière, à une densité de lumière moyenne supérieure ou égale à 2000 Cd/m² et les distances (d_{C}) sont inférieures ou égales à 2,5 fois une distance (d_{L}) entre la surface de découplage de la lumière (101) et les puces (3) de diode électroluminescente.

2. Dispositif d'éclairage selon la revendication 1, la distance (d_{L}) entre la surface de découplage de la lumière (101) et les puces (3) de diode électroluminescente étant inférieure ou égale à 5 mm.

3. Dispositif d'éclairage selon l'une quelconque des revendications précédentes, les puces (3) de diode électroluminescente présentant des dimensions latérales (L_{C}) de 300 µm ou moins.

4. Dispositif d'éclairage selon l'une quelconque des revendications précédentes, qui est conçu pour une dissipation de la chaleur, sans corps de refroidissement supplémentaire, par émission de chaleur au niveau de la surface de découplage de la lumière (101) et au niveau d'une surface externe arrière (201) du support arrière (2).

5. Dispositif d'éclairage selon l'une quelconque des revendications précédentes, les supports (1, 2) avant et arrière étant flexibles.

6. Dispositif d'éclairage selon l'une quelconque des revendications précédentes, dont la hauteur de construction (H_{B}) est inférieure ou égale à 10 mm, en particulier inférieure ou égale à 5 mm.

7. Dispositif d'éclairage selon l'une quelconque des revendications précédentes, un matériau promoteur d'adhérence (4), au moyen duquel une contrainte de traction est réalisée entre les supports (1, 2), étant disposé par endroits entre le support avant (1) et le support arrière (2).

8. Dispositif d'éclairage selon l'une quelconque des revendications précédentes, un matériau d'adaptation (5) de l'indice de réfraction étant disposé entre les puces (3) de diode électroluminescente et le support avant (1).

9. Dispositif d'éclairage selon l'une quelconque des revendications précédentes, le support avant (1) entourant une pluralité de cavités (15) séparées les unes des autres, chaque cavité (15) chevauchant une des puces (3) de diode électroluminescente et contenant un élément de conversion de luminescence (6) présentant une substance électroluminescente.

10. Dispositif d'éclairage selon l'une quelconque des revendications 1 à 8, le support avant (1) entourant une pluralité de cavités (15) séparées les unes des autres,
- chaque cavité (15) chevauchant une puce (3) de diode électroluminescente,
- une première zone partielle (15A), orientée vers la puce (3) de diode électroluminescente respective, de chaque cavité (15) contenant un élément de conversion de luminescence (6) présentant une substance électroluminescente et
- une deuxième zone partielle (15B), opposée à la puce (3) de diode électroluminescente respective, de chaque cavité (15) étant remplie d'un matériau, en particulier d'un gaz, qui présente un indice de réfraction inférieur à celui du matériau du support avant (1) qui délimite la cavité (15) dans le sens vers la surface de découplage de la lumière (101) et présentant en particulier une surface incurvée.

11. Dispositif d'éclairage selon l'une quelconque des revendications 9 ou 10, chaque cavité (15) présentant des dimensions latérales (L_{P}) qui sont à chaque fois inférieures ou égales au triple de la dimension latérale (L_{C}) correspondante de la puce (3) de diode électroluminescente que la cavité (15) chevauche.

12. Dispositif d'éclairage selon l'une quelconque des revendications précédentes, le support avant (1) contenant une couche (16) réfléchissant de manière diffuse au moyen de particules de diffusion.

13. Dispositif d'éclairage selon l'une quelconque des revendications précédentes, les puces (3) de diode électroluminescente présentant à chaque fois une couche de contact (34) transparente à la lumière orientée vers le support avant (1) et le support avant (1) présentant une couche de connexion (10) électrique qui est au moins par endroits transparente à la lumière, qui est en particulier directement adjacente aux couches de contact (34) des puces (3) de diode électroluminescente.

14. Dispositif d'éclairage selon la revendication 13, le support arrière (2) présentant au moins une piste conductrice (20A), qui est conçue pour la mise en contact électrique avant avec au moins une des puces (3) de diode électroluminescente et au moins un élément de pont (7) électrique étant disposé entre le support avant (1) et le support arrière (2) qui établit un contact électrique entre la piste conductrice (20A) du support arrière et la couche de connexion (10) électrique du support avant (1).

15. Dispositif d'éclairage selon la revendication 14, les puces (3) de diode électroluminescente et l'élément de pont (7) électrique présentant environ la même hauteur (H_{C}).
